(19) Europäisches Patentamt
European Patent Office
Office européen des brevets

(11) **EP 1 911 859 A1**

(12) **EUROPEAN PATENT APPLICATION**
published in accordance with Art. 153(4) EPC

(43) Date of publication:
**16.04.2008 Bulletin 2008/16**

(51) Int Cl.:
***C23C 16/26*** (2006.01)     ***C01B 31/02*** (2006.01)
***C03C 17/22*** (2006.01)

(21) Application number: **06767832.6**

(22) Date of filing: **04.07.2006**

(86) International application number:
**PCT/JP2006/313315**

(87) International publication number:
**WO 2007/004647 (11.01.2007 Gazette 2007/02)**

(84) Designated Contracting States:
**DE FR GB**

(30) Priority: **04.07.2005 JP 2005194628**

(71) Applicant: **National Institute of Advanced Industrial Science and Technology Tokyo 100-8921 (JP)**

(72) Inventors:
- **HASEGAWA, Masataka**
  **c/o Nat. Inst. of Adv. Ind.**
  **Tsukuba-shi,**
  **Ibaraki, 3058565 (JP)**
- **TSUGAWA, Kazuo**
  **c/o Nat. Inst. of Adv. Ind.**
  **Tsukuba-shi,**
  **Ibaraki, 3058565 (JP)**

- **KOGA, Yoshinori**
  **c/o Nat. Inst. of Adv. Ind.**
  **Tsukuba-shi,**
  **Ibaraki, 3058565 (JP)**
- **ISHIHARA, Masatou**
  **c/o Nat. Inst. of Adv. Ind.**
  **Tsukuba-shi,**
  **Ibaraki, 3058565 (JP)**
- **IIJIMA, Sumio**
  **c/o Nat. Inst. of Adv. Ind.**
  **Tsukuba-shi,**
  **Ibaraki, 3058565 (JP)**

(74) Representative: **Maiwald, Walter et al Maiwald Patentanwalts GmbH Elisenhof Elisenstrasse 3 80335 München (DE)**

(54) **CARBON FILM**

(57)     A carbon film including: carbon grains having substantially the same grain size in the range of 1 nm to 1,000 nm, and preferably in the range of 2 nm to 200 nm, in the thickness-wise direction of the carbon film; and an amorphous substance for suppressing generation of impurities accompanied by formation of the carbon grains and/or for suppressing growth of said carbon grains, the amorphous substance existing at least on the surfaces of the carbon grains in a grain boundary between the carbon grains and/or gaps between the carbon grains. Such a carbon film has excellent optical properties such as high transparency, a high refractive index and small birefringence, and exhibits excellent electrical insulation. Further, the carbon film can be coated on various substrates with high adhesion and can be formed at a low temperature. Therefore, the carbon film is extremely useful for application to an optical device, a wrist watch, an electronic circuit substrate, a grinding tool or a protection film.

FIG. 25

**Description**

TECHNICAL FIELD

The present invention relates to a carbon film and a carbon film laminate having new properties; an optical device, an optical glass, a lens, a wrist watch, an electronic circuit substrate, a grinding tool, a low-friction protection film, a vehicle engine component, a mechanical component, and a health appliance provided with the same; and a method and apparatus for manufacturing the carbon film and the carbon film laminate.

BACKGROUND ART

A carbon-based thin film has various excellent characteristics such as high hardness, thermal conductivity, an electric insulating property, transparency, a high refractive index, chemical resistance, a low friction property, and a low abrasion property. Recently, due to its excellent environmental compatibility and biocompatibility, it has been desired to use a carbon-based thin film as a coating for improving the performance of various substrates. Especially, a diamond-like carbon film and a diamond film are thin carbon-based films having excellent properties, and improvement in the coating technique for enhancing mechanical, optical, and electrical functions of various substrates has been expected. However, at present, diamond-like carbon and diamond have the following problems caused by the characteristics of diamond-like carbon and diamond. Consequently, development of a new carbon film has been desired in order to solve such problems.

In the formation of a carbon film on a substrate, when glass is used as a substrate, it has been expected to be applied for scratch resistance on a surface due to the high hardness thereof, and for optical devices having new functions realized by the high refractive index thereof. For example, a method of forming a micro-crystal diamond (hereinafter simply referred to as MCD) film on a glass substrate by a CVD treatment is already known (for example, see Patent Document 1 and Non-Patent Document 1).

For applying the carbon film to an optical protective film, it has been attempted to utilize the high transmittance of a diamond film. It is known that the transmittance becomes higher as the grain size of the diamond grains coated on the glass surface becomes smaller and the surface roughness becomes smaller.

However, in a conventional CVD treatment, since the formed MCD has a grain size as large as 0.3 $\mu$m to several $\mu$m, the obtained MCD film lacks surface flatness and satisfactory transmittance cannot be obtained. For improving the transmittance, it is necessary to form a flat surface by grinding, and the cost therefor is one of the obstacles to becoming widespread.

Conventional Nano-Diamond Synthesis Method and Problems thereof

Therefore, it has been attempted to develop a technique of forming a flat surface without the need of grinding by making the grain size of the diamond grains smaller.

As well known, a gas-phase synthesis of diamond requires the use of a gaseous mixture of a carbon source such as methane ($CH_4$) and hydrogen, and a hydrogen-rich atmosphere in which the concentration of the carbon source is about 1% (or less). For synthesizing a high quality diamond film, the upper limit of the concentration of the carbon source is about 1%. By increasing the concentration of the carbon source, the film growth rate can be increased. However, by increasing the concentration of the carbon source, non-diamond components such as amorphous carbon within the film increase. As a result, transparency deteriorates, thereby causing quality deterioration of the diamond.

Nevertheless, by increasing the concentration of the carbon source, the grain size diamond decreases. In a conventional gas-phase synthesis of nano-crystal diamond, high concentration of the carbon source, which can be said as a requirement of synthesizing low quality diamond, has been used. Further, synthesis by fullerene ($C_{60}$) and argon in a system containing no hydrogen has also been performed. Representative gas compositions of nano-crystal diamond synthesis by high concentration of carbon source using microwave plasma are exemplified below.

   1: $C_{60}$(0.1%) + Ar
   2: $C_{60}$(0.1%) + Ar + $H_2$(2%)
   3: $CH_4$(1%) + Ar
   4: $CH_4$(1%) + Ar + $H_2$(2%)
   5: $CH_4$ (5 to 30%) + $H_2$

Zuiker et al. of Argonne National Laboratory succeeded for the first time in forming a nano-crystal diamond film having an extremely low coefficient of friction (0.04) by a process using a system of fullerene + Ar and a small amount of hydrogen added thereto, as indicated in item 2 above (see Non-Patent Document 2). Especially, in a carbon source concentration as high as 20% or more, the nucleus formation density can be increased, and it is suggested that a nano-crystal diamond film having an extremely smooth surface can be obtained. However, as described above, such a film is opaque so as to assume a black color. Therefore, this film cannot be utilized in optical application. Moreover, since electrical resistivity is small, the film cannot be used as an insulator. For this reason, there has been desired the development of a carbon film capable of maintaining transparency even when the grain size becomes small and exhibiting electrical insulation, and a method of producing such a carbon film.

When a carbon film coating for a glass-protecting film is used, high adhesion is required. For example, a technique of coating diamond on a glass substrate is disclosed in Patent Document 1. In this document, the coating exhibits good performance in a tape test.

However, for application to coating of front glass of an automobile and coating on a spectacle lens, etc., a coating capable of maintaining higher adhesion as well as high transmittance is required.

Moreover, for optical application to lenses for spectacles, cameras and cinema projectors, it is important that the coating layer has a high refractive index and exhibits no birefringence.

However, when MCD is formed by the CVD method which is a typical coating method, it is extremely difficult to synthesize MCD exhibiting no birefringence due to thermal strain and residual stress. Further, density is likely to be lowered, and the refractive index is usually lowered considerably. Therefore, it has been a problem that MCD coating is not suitable for optical application.

Further, as a carbon-based thin film has high hardness and a low friction/low abrasion characteristic, application of carbon-based thin film coating to sliding portions of mechanical components made of iron or stainless steel has been expected. However, diamond-like carbon film coating and a diamond film are extremely difficult to put to practical use for the following problems. One problem is that carbon atoms as the component element of the film impregnate into the iron substrate, and as a result, the film is not deposited. Another problem is that the substrate becomes brittle. On the other hand, there has been developed a technique of forming an intermediate layer (adhesion-reinforcing layer), which is a thin film of titanium, chromium, or a nitride thereof, on the iron-based substrate prior to the coating of carbon-based thin film. However, there are still problems in that the cost for forming the intermediate layer (adhesion-reinforcing layer) is expensive, and in that the adhesion of the coating is still low. For this reason, there have been demands for development of a method of forming an intermediate layer (adhesion-reinforcing layer) which is simpler and can be performed at a low cost, and an intermediate layer (adhesion-reinforcing layer) with higher adhesion.

Further, when copper is used as a substrate, since a diamond-like carbon and a diamond film exhibit a high electric insulating property, it has been desired to apply a diamond-like carbon film coating or a diamond film coating on an electronic circuit substrate having a copper surface. However, it is extremely difficult to deposit a diamond-like carbon film or a diamond film on a copper surface. Even if it is deposited, there is a big problem in that adhesion of the film to the copper surface is low, and hence, the film is easily delaminated from the surface. For solving this problem, formation of an intermediate layer of titanium or a nitride thereof has been attempted, as in the case of the iron-based substrate described above. However, this also results in a problem with cost or low adhesion. Further, when a CVD method which is a typical method is used for forming, especially, a diamond coating, boron in the atmosphere is easily taken into the film without intentional doping. Therefore, there is a big problem in that the electric insulating property of the diamond coating is lowered.

Further, as a method of coating a carbon film on a plastic substrate, coating of a diamond-like carbon film on a PET bottle has been put to practical use. However, there has been desired the use of plastics with the diamond coating at a higher temperature and the coating of plastics with diamond for optical application. For example, in recent years, 90% or more of spectacle lenses are made of plastics. If it becomes possible to form diamond coated plastic spectacle lenses, it would become possible to manufacture a high functional lens which utilizes properties such as resistance to scratching of the lens and high refractive index of diamond. However, since synthesis of the diamond film requires a temperature as high as at least 600°C, at present, diamond is not suitable as a coating material for plastics.

[Patent Document 1] Japanese Unexamined Patent Application, First Publication No. Hei 10-95694
[Non-Patent Document 1] Diamond and Related Materials Vol. 7, pp. 1639-1646 (1998)
[Non-Patent Document 2] Thin Solid Films Vol. 270, pp. 154-159 (1995)

DISCLOSURE OF INVENTION

PROBLEMS TO BE SOLVED BY THE INVENTION

The invention takes into consideration the above circumstances of carbon films represented by diamond-like carbons and diamond.

Therefore, an object of the present invention is to provide a carbon film and a laminate having optical characteristics of maintaining high transparency even when the grain size becomes smaller, high refractive index and small birefringence; exhibiting an excellent electric insulating property; capable of being coated with good adhesion, irrespective of the type of substrate including iron, copper and plastics; and capable of being formed at a low temperature. Further, another object of the present invention is to provide an optical device, an optical glass, a wrist watch, an electronic circuit substrate, or a grinding tool using the carbon film or the laminate.

MEANS FOR SOLVING THE PROBLEMS

The present inventors have made extensive and intensive studies in order to form a carbon film and a laminate having the various characteristics described above. As a result, the present inventors have found that a carbon film and laminate thereof exhibiting excellent performance can be formed by conducting a CVD treatment using a specific apparatus under specific conditions. The present invention has been completed based on these findings.

According to the present application, the following inventions are provided.

<1> A carbon film including: carbon grains having substantially the same grain size in the range of 1 nm to 1,000 nm, and preferably in the range of 2 nm to 200 nm, in the thickness-wise direction of the carbon film; and an amorphous substance for suppressing generation of impurities accompanied by formation of the carbon grains and/or for suppressing growth of the carbon grains, the amorphous substance existing at least on the surfaces of the carbon grains in a grain boundary between the carbon grains and/or gaps between the carbon grains.

<2> The carbon film according to <1>, wherein the carbon grains have an approximate spectrum curve obtained by superimposing a peak fitting curve B at a Bragg angle ($2\theta \pm 0.5°$) of 41.7° and a baseline on a peak fitting curve A at a Bragg angle ($2\theta \pm 0.5°$) of 43.9° in an X-ray diffraction spectrum by a $CuK\alpha_1$ ray, and wherein the peak fitting curve A, the peak fitting curve B, and the baseline are represented by a Pearson VII function, an asymmetric normal distribution function, and a linear function, respectively.

<3> The carbon film according to <2>, wherein the intensity ratio of the peak fitting curve B to the peak fitting curve A is at a minimum 5% and at a maximum 90%.

<4> The carbon film according to any one of <1> to <3>, wherein the impurities accompanied by formation of the carbon grains is amorphous carbon or graphite.

<5> The carbon film according to any one of <1> to <4>, wherein the amorphous substance is at least one member selected from the group consisting of Si, $SiO_2$, Ti, $TiO_2$, $HfO_2$, and ZnO.

<6> The carbon film according to <5>, wherein the amorphous substance exists within the carbon film in the range from 0.01 to 10 at%, and preferably in the range from 0.1 to 10 at%.

<7> The carbon film according to any one of <1> to <6>, wherein the amorphous substance is formed at a furnace temperature in the range from room temperature to 600°C.

<8> The carbon film according to any one of <1> to <7>, which exhibits an average transmittance of 60% or more in the wavelength region of 400 to 800 nm, an electrical resistivity of $1 \times 10^7$ Ωcm or more at 100°C, a refractive index of 1.7 or more at a wavelength of 589 nm, a thermal conductivity of 20 W/mK or more at 25°C, and surface flatness with a surface roughness (Ra) of 20 nm or less.

<9> A carbon film laminate including the carbon film of any one of <1> to <8> deposited on a substrate.

<10> The carbon film laminate according to <9>, which further includes an adhesion-reinforcing layer provided between the substrate and the carbon film for improving adhesion between both.

<11> The carbon film laminate according to <9> or <10>, wherein the substrate is at least one member selected from the group consisting of insulating materials including glass, quartz, and diamond; semiconductors including silicon; conductive materials including iron, stainless steel, molybdenum, aluminum, copper, and titanium; ceramic materials including tungsten carbide, alumina, and boron nitride; and plastic materials including PES, PET, PPS, and polyimide.

<12> The carbon film laminate according to <10>, wherein the adhesion-reinforcing layer includes amorphous Si and/or $SiO_2$.

<13> A method of forming a carbon film including continuously or discontinuously supplying into a chamber of a plasma generation furnace a carbon-containing gas, a hydrogen gas, and a gas which forms an amorphous substance for suppressing generation of an impurity accompanied by formation of carbon grains and/or for suppressing growth of the carbon grains, in a plasma state toward a substrate in a downflow manner, the substrate temperature being in the range of room temperature to 600°C.

<14> The method according to <13>, wherein the amorphous substance is at least one member selected from the group consisting of Si, $SiO_2$, Ti, $TiO_2$, $HfO_2$, and ZnO.

<15> The method according to <13>, wherein the gas for forming the amorphous substance is a silicon-containing gas.

<16> The method according to <15>, wherein the silicon-containing gas is generated by exposing plasma to bulk-like silicon or $SiO_2$.

<17> The method according to <15> or <16>, wherein the concentration of the silicon-containing gas is 10 mol% or less.

<18> The method according to <13>, which further includes adding carbon dioxide.

<19> The method according to <13>, which further includes performing a heat treatment after depositing the carbon film.

<20> A method of forming a carbon film laminate, including: providing a substrate; forming an adhesion-reinforcing layer on said substrate at a furnace temperature within the range of room temperature to 600°C by a plasma CVD using a surface wave; and forming a carbon film on the adhesion-reinforcing layer by the method of <13>.

<21> A carbon film deposition apparatus including: a plasma-generating unit; a supply unit for generating a silicon-containing gas by exposing plasma to bulk-like silicon or $SiO_2$, and supplying the silicon-containing gas together with source gases including carbon-containing gas and hydrogen in a plasma state toward a substrate in a downflow manner; and a cooling unit for cooling the substrate temperature to a temperature within the range of room temperature to 600°C.

<22> An optical device provided with the carbon film of <1> or the carbon film laminate of <9>.

<23> An optical glass provided with the carbon film of <1> or the carbon film laminate of <9>.

<24> A wrist watch provided with the carbon film of <1> or the carbon film laminate of <9>.

<25> An electronic circuit substrate provided with the carbon film of <1> or the carbon film laminate of <9>.

<26> A grinding tool provided with the carbon film of <1> or the carbon film laminate of <9>.

<27> A protection film provided with the carbon film of <1> or the carbon film laminate of <9>.

EFFECT OF THE INVENTION

A carbon film and a carbon film laminate according to the present invention have optical characteristics of maintaining high transparency even when the grain size becomes small, a high refractive index, and small birefringence; exhibit an excellent electric insulating property; can be coated with satisfactory adhesion, irrespective of the type of the substrate including iron, copper, and plastics; and can be formed at a low temperature.

As the carbon film and the carbon film laminate according to the invention has the characteristics described above, it can be utilized in a protection film for glass with large area, an optical material with high refractive index, a highly thermal-conductive heat sink, an electrode material, a protection film for a machining tool, a grinding tool, an electron emission material, a low-friction/low-abrasion coating for an engine component, a protection film for chemical resistance, a high frequency device (SAW device), a gas barrier coating material, a tribo-electric material, a protection film of a cover glass for a wrist watch or a mobile telephone, a biocompatible material, a biosensor, etc.

BRIEF DESCRIPTION OF THE DRAWINGS

FIG. 1 is a diagram illustrating an X-ray diffraction spectrum of an example of a carbon film of the invention by $CuK\alpha_1$ X rays, and the result of peak fitting. In the drawing, white circles indicate measured values.

FIG. 2 is a diagram illustrating a typical X-ray diffraction spectrum of diamond by $CuK\alpha_1$ X rays ((111) reflection peak), and a result of peak fitting. In the drawing, white circles indicate measured values.

FIG. 3(A) is a diagram illustrating a configuration of a carbon film depositing apparatus according to the invention and FIG. 3(B) is a diagram illustrating a configuration of a conventional CVD apparatus.

FIG. 4 is a photograph of a carbon film formed on a glass substrate (300 mm $\times$ 300 mm) by the method of the present invention.

FIG. 5 is a Raman scattering spectrum of an example of the carbon film of the present invention.

FIG. 6 is a diagram illustrating photographs of a cross-section of the carbon film of the present invention formed on a glass substrate, taken with a high resolution transmission electron microscope (HRTEM). FIG. 6(a) is a photograph showing an interface between the glass substrate and the carbon film. FIG. 6(b) is a photograph showing the outermost surface of the carbon film. FIG. 6(c) is a photograph showing an electron beam refraction image of the carbon film. FIG. 6(d) is a diagram illustrating an electron energy loss spectrum (EELS) (C-K shell absorption edge).

FIG. 7 is a photograph of a cross-section of an example of the carbon film of the present invention formed on a glass substrate, taken with a scanning electron microscope.

FIG 8 is a photograph of the surface of the carbon film (film thickness: 1.6 $\mu$m) of the present invention formed on a quartz substrate (Ra = 0.87 nm), taken with an atomic force microscope (AFM).

FIG 9 is a wavelength dispersion graph of the transmittance in a visible light region of an example of the carbon film (about 500 nm thickness) of the present invention formed on a glass substrate.

FIG. 10 is a wavelength dispersion graph of the refractive index and extinction coefficient of an example of the carbon film of the present invention formed on a glass substrate.

FIG. 11 is a schematic diagram illustrating a method of measuring birefringence of an example of the carbon film of the present invention formed on a glass substrate.

FIG. 12 is a wavelength dispersion graph of the phase difference and ∆nd of an example of the carbon film of the present invention formed on a glass substrate (film thickness: about 200 nm). In the data of the drawing, measured values only for the glass substrate are subtracted from measured values for the glass substrate having the carbon film formed thereon.

FIG 13 is a graph illustrating an example of the measurement result of a scratch test with respect to one certain measuring point of an example of the carbon film of the present invention formed on a glass substrate (film thickness: about 600 nm). In the graph, the abscissa denotes the scratch distance and the ordinate denotes the penetration depth.

FIG. 14 is a graph illustrating the temperature dependence of the electrical resistivity of an example of the carbon film of the present invention formed on a glass substrate (film thickness: about 500 nm).

FIG. 15(a) is a Raman scattering spectrum of the carbon film of the present invention formed on a borosilicate substrate at a temperature as low as about room temperature (CVD treatment temperature: 40°C), and FIG. 15(b) is a Raman scattering spectrum of the carbon film of the present invention formed on a Si substrate at a temperature as low as about room temperature (CVD treatment temperature: 31°C).

FIG. 16 is a diagram illustrating Raman scattering spectra of an example of the carbon film of the present invention formed on various kinds of substrates. The substrates are (a) Si, (b) quartz glass, (c) Ti, (d) WC, (e) Cu, (f) Fe, (g) soda lime glass, (h) stainless steel (SUS 430), and (i) Al.

FIG. 17 is a Raman scattering spectrum of an example of the carbon film of the present invention formed on a PPS resin substrate at a substrate temperature of 28°C.

FIG 18 is an optical photomicrograph of an example of discontinuous carbon film grains according to the present invention formed on a glass substrate.

FIG. 19 is a diagram illustrating a grinding tool including a carbon film of the present invention and quartz glass.

FIG. 20 is a diagram illustrating an optical device including a carbon film of the present invention and glass.

FIG. 21 is a diagram illustrating photographs showing the glass protection film effect of the carbon film of the present invention. FIG. 21 (A) shows a borosilicate glass coated with a carbon film of the present invention, and FIG. 21(B) shows a borosilicate glass without coating. Both FIGS. 21(A) and (B) show the optical photomicrographs after rubbing with sand paper (No. 400) by 800 or more testers.

FIG 22 is a photograph of a wrist watch provided with a laminate including the carbon film of the present invention and a quartz glass as a wind shield.

FIG. 23 is a schematic diagram illustrating an electronic circuit substrate obtained by forming an electronic pattern with copper on a laminate including an aluminum plate and a carbon film of the present invention.

FIG. 24 is a schematic diagram illustrating a cross-section of the carbon film of the present invention formed on a silicon substrate, as observed with a high resolution transmission electron microscope.

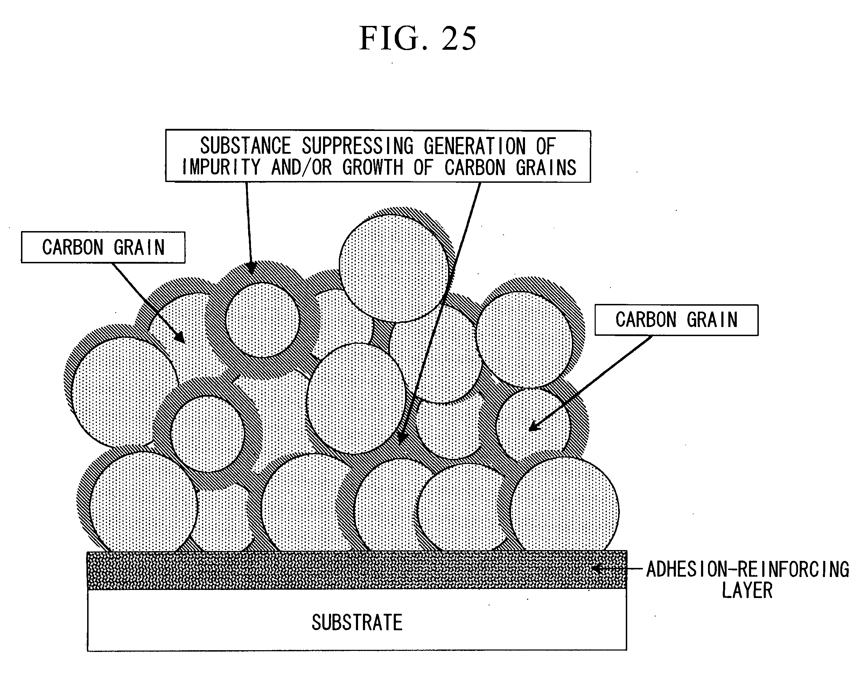

FIG. 25 is a schematic diagram illustrating a carbon film laminate according to the present invention including a carbon film and an adhesion-reinforcing layer, the carbon film including very fine carbon grains with substantially the same grain size in a thickness-wise direction of the carbon film and which is provided with a substance for suppressing formation of impurities such as amorphous carbon or graphite accompanied by formation of the carbon grains and/or for suppressing growth of the carbon grains existing in grain boundaries between the carbon grains and/or gaps between the carbon grains; and the adhesion-reinforcing layer being provided between said substrate and said carbon film for improving adhesion between both.

FIG. 26 is a diagram illustrating distribution of silicon (Si) and oxygen (O) contained in the carbon film according to the invention in the depth-wise direction of the film, as measured by secondary ion mass spectroscopy. In the carbon film of FIG. 26(A), the amount of the source gas for forming amorphous $SiO_2$ was 10 to 20 times of the source gas in the carbon film of FIG. 26(B).

## BEST MODE FOR CARRYING OUT THE INVENTION

The carbon film according to the invention is a carbon film including: extremely fine carbon grains having substantially the same grain size in a thickness-wise direction of the carbon film; and a substance for suppressing generation of impurities accompanied by formation of the carbon grains and/or for suppressing growth of the carbon grains, said amorphous substance existing at least on the surfaces of the carbon grains in a grain boundary between the carbon grains and/or gaps between the carbon grains.

Specifically, the carbon grains are characterized in that they have substantially the same grain size in the range from 1 nm to 1,000 nm, and preferably in the range from 2 nm to 200 nm, and exist in the thickness-wise direction of the carbon film. Here, the expression "have substantially the same grain size in the range from 1 nm to 1000 nm" means that 51 % or more of all the carbon grains have the grain size in the range from 1 nm to 1000 nm. Likewise, the expression "having substantially the same grain size in the range from 2 nm to 200 nm" means that 51 % or more of all the carbon grains have the grain size in the range from 2 nm to 200 nm.

The carbon film according to the invention can be obtained by mainly employing a specific production apparatus under specific production conditions. For producing the carbon film, it is necessary to use a surface wave plasma generating apparatus capable of forming a film with a large area. In addition, it is necessary that the surface wave plasma generating apparatus include a supply unit which supplies the substance for suppressing the generation of impurities such as amorphous carbon or graphite accompanied by formation of the carbon grains and/or for suppressing growth of the carbon grains, as well as source gases of the carbon grains such as a carbon-containing gas, a hydrogen gas, and a carbon dioxide gas if necessary, toward a substrate within a chamber in a downflow manner. As the operation conditions, it is necessary to select the concentration and the molar ratio of the source gases, the reaction time, or the like, and to perform the operation at a relatively low temperature.

With respect to a method of producing the carbon film and/or a carbon film laminate according to the present invention, the scheme thereof will be described below with examples. For example, fine diamond grains are adhered to a substrate such as glass, silicon, iron, titanium, copper or plastic by an ultrasonic treatment. Then, in a low-temperature surface wave plasma CVD apparatus, a gas containing 97% hydrogen, 1% carbonic acid gas, 1% methane gas and 1% silane gas is supplied toward the substrate within the chamber in a downflow manner to perform a surface wave plasma treatment under a pressure of $1 \times 10^2$ Pa.

The treatment time is in the range from several hours to several tens of hours and the treatment temperature is in the range from room temperature to 600°C. By the treatment as described above, fine carbon grains having a grain size of 2 to 30 nm are deposited on the substrate surface. By extending the time of the surface wave plasma treatment, carbon grains can be deposited compactly without gaps, to thereby form a film having a thickness of 2 $\mu$m or more.

When a copper substrate is used, the fine carbon grains are deposited without adhesion of the fine diamond grains by the ultrasonic treatment. Furthermore, as a result of various film tests with respect to the deposition layer of the fine carbon grains, it was found that the layer exhibited outstanding properties such as a transmittance of 90% or more to visible light when the film thickness is 500 nm, high adhesion to the substrate, a high refractive index (2.1 or more at wavelength of 589 nm), hardly any birefringence, surface flatness with a surface roughness (Ra) of 20 nm or less when a film having a thickness of 2 $\mu$m is formed, and an electric resistivity as high as $10^7$ $\Omega$cm or more at a temperature of 100°C. As described above, the carbon grains and the carbon film formed by the above-described method have high transparency and high adhesion which a conventional carbon film does not possess, and exhibits excellent performance such that it is capable of being directly coated on an iron-based substrate or a copper substrate.

The carbon film according to the present invention is preferably formed on the above-described substrates.

As the substrate, a conventional substrate may be used, for example, an insulating material such as glass, quartz, or diamond; a semiconductor such as silicon; a metal such as iron, stainless steel, molybdenum, aluminum, copper, or titanium; a ceramic material such as tungsten carbide, alumina, or boron nitride; or a plastic material such as PES, PET, PPS, or polyimide may be used.

Hereinafter, the case where glass is used as a representative example of the substrate will be described. The glass substrate includes, for example, various types of conventional glass such as soda lime glass and borosilicate glass. The thickness of glass is not particularly limited, and is appropriately selected depending on the application of the final product. In general, the thickness is in the range from 100 nm to 0.5 mm.

For forming the carbon film according to the present invention, firstly, nano-crystal diamond grains, cluster diamond grains, or graphite cluster diamond grains are adhered to the glass substrate. Alternatively, adamantane ($C_{10}H_{16}$), a derivative thereof, or a multimeric compound thereof is adhered to the glass substrate.

Typically, the nano-crystal diamond grains are diamond grains which are produced by explosion synthesis of diamond, or by high temperature/high pressure synthesis of diamond, followed by pulverizing the synthesized diamond; the cluster diamond grains are aggregates of the nano-crystal diamond grains; and the graphite cluster diamond grains are cluster diamond grains which contain large amounts of graphite or amorphous carbon components.

With respect to the nano-crystal diamond, a colloidal solution in which the nano-crystal diamond produced by explosion synthesis is dispersed in a solvent is sold by NanoCarbon Research Institute Co., Ltd., and a nano-crystal diamond powder produced by pulverization or a product in which the powder is dispersed in a solvent is sold by Tomei Diamond Co., Ltd. The average grain size of the nano-crystal diamond grains used in the present invention is in the range from 4 nm to 100 nm, and preferably from 4 nm to 10 nm. The nano-crystal diamond grains are described in detail in, for example, "Hiroshi Makita, New Diamond Vol. 12 No. 3, pp. 8 to 13 (1996).

For adhering the nano-crystal diamond grains to a glass substrate, the nano-crystal diamond grains are dispersed in water or ethanol. At this time, for improving dispersibility, a surfactant (e.g., lauryl sulfate ester sodium salt or sodium oleate) is added. Then, the glass substrate is immersed in the dispersion and cleaned by an ultrasonic cleaner. Subsequently, the substrate is immersed in ethanol and cleaned by the ultrasonic cleaner. Finally, the substrate is taken out and dried.

By performing the above-described operations, a glass substrate having nano-crystal diamond grains adhered to the surface thereof can be obtained. The nano-crystal diamond grains are adhered to the surface of the glass substrate by a physical force in the course of the ultrasonic cleaning operation, which buries a part of the grains in the substrate surface. The number of the nano-crystal diamond grains adhered to the substrate surface is preferably in the range from $10^9$ to $10^{12}$ grains per 1 $cm^2$, and more preferably from $10^{10}$ to $10^{11}$ grains per 1 $cm^2$. The diamond grains adhered to the glass substrate serve as seed crystals for the growth of the carbon film in the surface wave plasma treatment.

The number of nanocrystal diamond grains adhered to the surface of the glass substrate can be reduced by diluting the concentration of the nano-crystal diamond grains dispersed in the dispersion medium (water, ethanol, etc.). In this manner, it becomes possible to lower the nucleus generation density of the carbon grains in the surface wave plasma treatment and obtain, instead of a continuous film, a discontinuous film composed of aggregates of the carbon grains. In the aggregates, the surface density of the carbon grains can be controlled by the concentration of the nano-crystal diamond grains in the dispersion fluid. The grain size of the carbon grains can be controlled by the surface wave plasma treatment time. Further by making the concentration extremely low, it becomes possible to form an aggregate composed of the carbon grains isolated on the glass substrate. Furthermore, by treating the aggregate with hydrofluoric acid or the like and removing the glass substrate from the aggregate, it becomes possible to obtain only the carbon grains.

As an alternative method of adhering nano-crystal diamond grains to a glass substrate, a method of spin-coating the dispersion of the nano-crystal diamond to the glass substrate and drying can be mentioned. By this method, the same adhesion effect as that in the ultrasonic cleaning method can be achieved.

The cluster diamond grains are agglomerates of the nano-crystal diamond produced by the explosion synthesis method and exhibit excellent transparency. The cluster diamond grains are sold, for example, by Tokyo Diamond Tools Mfg. Co., Ltd. The average grain size of the cluster diamond used in the present invention is in the range from 4 nm to 100 nm, and preferably from 4 nm to 10 nm. The cluster diamond grains are described in detail in, for example, "Hiroshi Makita, New Diamond Vol. 12 No. 3, pp. 8 to 13 (1996).

For adhering the cluster diamond grains to a glass substrate, the cluster diamond grains are dispersed in water or ethanol. At this time, for improving dispersibility, a surfactant (e.g., lauryl sulfate ester sodium salt or sodium oleate) is added. Then, the glass substrate is immersed in the dispersion and cleaned by an ultrasonic cleaner. Subsequently, the substrate is immersed in ethanol and cleaned by the ultrasonic cleaner. Finally, the substrate is taken out and dried. By performing the above-described operations, a glass substrate having cluster diamond grains adhered to the surface thereof can be obtained. The cluster diamond grains are adhered to the surface of the glass substrate by a physical force in the course of the ultrasonic cleaning operation, which buries a part of the grains in the substrate surface. The number of the cluster diamond grains adhered to the surface of the glass substrate is preferably in the range from $10^9$ to $10^{12}$ grains per 1 $cm^2$, and more preferably from $10^{10}$ to $10^{11}$ grains per 1 $cm^2$. The diamond grains adhered onto the glass substrate serve as seed crystals for the growth of the carbon film in the surface wave plasma treatment.

The number of cluster diamond grains adhered to the surface of the glass substrate can be reduced by diluting the concentration of the cluster diamond grains dispersed in the disperson medium (water, ethanol, or the like). In this manner, it becomes possible to lower the nucleus generation density of the carbon grains in the surface wave plasma treatment and obtain, instead of a continuous film, a discontinuous film composed of an agglomerate of the carbon grains. In the agglomerate, the surface density of the carbon grains can be controlled by the concentration of the nano-crystal diamond grains in the dispersion fluid. The grain size of the carbon grains can be controlled by the surface wave plasma treatment time. Further by making the concentration extremely low, it becomes possible to form an agglomerate composed of the carbon grains isolated on the glass substrate. Furthermore, by treating the agglomerate with hydrofluoric acid or the like and removing the glass substrate from the agglomerate, it becomes possible to obtain only the carbon grains.

As an alternative method of adhering cluster diamond grains onto a glass substrate, a method of spin-coating the dispersion of the cluster diamond to the glass substrate and drying can be mentioned. By this method, the same adhesion effect as that in the ultrasonic cleaning method can be achieved.

For adhering the graphite cluster diamond grains to a glass substrate, the graphite cluster diamond grains are dispersed in water or ethanol. At this time, for improving dispersibility, a surfactant (e.g., lauryl sulfate ester sodium salt or sodium oleate) is added. Then, the glass substrate is immersed in the dispersion and cleaned by an ultrasonic cleaner. Subsequently, the substrate is immersed in ethanol and cleaned by the ultrasonic cleaner. Finally, the substrate is taken out and dried. By performing the above-described operations, a glass substrate having graphite cluster diamond grains adhered on the surface thereof can be obtained. The graphite cluster diamond grains are adhered to the surface of the glass substrate by a physical force in the course of the ultrasonic cleaning operation, which buries a part of the grains in the substrate surface. The number of the graphite cluster diamond grains adhered to the surface of the glass substrate is preferably in the range from $10^9$ to $10^{12}$ grains per 1 $cm^2$, and more preferably from $10^{10}$ to $10^{11}$ grains per 1 $cm^2$. The diamond grains adhered to the glass substrate serve as seed crystals for the growth of the carbon film in the surface wave plasma treatment.

The number of the graphite cluster diamond grains adhered to the surface of the glass substrate can be reduced by diluting the concentration of the graphite cluster diamond grains dispersed in a disperson medium (water, ethanol, or the like). In this manner, it becomes possible to lower the nucleus generation density of the carbon grains in the surface wave plasma treatment and obtain, instead of a continuous film, a discontinuous film composed of an agglomerate of the carbon grains. In the agglomerate, the surface density of the carbon grains can be controlled by the concentration of the graphite cluster diamond grains in the dispersion fluid. The grain size of the carbon grains can be controlled by the surface wave plasma treatment time. Further, by making the concentration extremely low, it becomes possible to form an agglomerate composed of the carbon grains isolated on the glass substrate. Furthermore, by treating the agglomerate with hydrofluoric acid or the like and removing the glass substrate from the agglomerate, it becomes possible to obtain only the carbon grains. Alternatively, when a continuous film is formed on the substrate, an independent film can be obtained by removing the substrate.

As an alternative method of adhering graphite cluster diamond grains to a glass substrate, a method of spin-coating the dispersion of the graphite cluster diamond to the glass substrate and drying can be mentioned. By this method, the same adhesion effect as that in the ultrasonic cleaning method can be achieved.

For adhering adamantane, a derivative thereof, or a multimeric compound thereof on the glass substrate, the adamantane, the derivative thereof, or the multimeric compound thereof is dissolved in a solvent (e.g., ethanol, hexane, or acetonitrile). Then the substrate is immersed in the solution and cleaned by an ultrasonic cleaner. Subsequently, the substrate is taken out and dried. By performing such operations, a glass substrate having the adamantane, the derivative thereof, or the multimeric compound thereof adhered to the surface thereof can be obtained.

Adamantane is a molecule represented by the molecular formula $C_{10}H_{16}$, and is in the form of a molecular crystal (at room temperature and under atmospheric pressure) exhibiting a sublimation property and having a diamond-like structure. Adamantane is manufactured in the course of petroleum refining. A powder of adamantane, a derivate thereof, and a multimeric compound thereof are sold by Idmitsu Kousan Co., Ltd.

It is possible to reduce the adhesion ratio of the adamantane, the derivate thereof, or the multimeric compound thereof adhered to the substrate surface by diluting the concentration of the adamantane, the derivate thereof, and the multimeric compound thereof to be dissolved in the solvent. In this manner, it becomes possible to lower the nucleus generation density of the carbon grains in the surface wave plasma treatment and obtain, instead of a continuous film, a discontinuous film composed of an agglomerate of the carbon grains. In the agglomerate, the surface density of the carbon grains can be controlled by the concentration of the adamantane, the derivate thereof, and the multimeric compound thereof in the dispersion fluid. The grain size of the carbon grains can be controlled by the surface wave plasma treatment time. Further, by making the concentration extremely low, it becomes possible to form an agglomerate composed of the carbon grains isolated on the glass substrate. Furthermore, by treating the agglomerate with hydrofluoric acid or the like and removing the glass substrate from the agglomerate, it becomes possible to obtain only the carbon grains.

As an alternative method of adhering adamantane, the derivate thereof, and the multimeric compound thereof to a glass substrate, a method of spin-coating a solution of the adamantane, the derivate thereof, and the multimeric compound to the glass substrate and drying can be mentioned. By this method, the same adhesion effect as that in the ultrasonic cleaning method can be achieved.

Next, in the present invention, the glass substrate having the diamond grains, adamantane, the derivative thereof, or the multimetric compound thereof adhered to the surface thereof (hereinafter, simply referred to as the glass substrate) is treated using a microwave plasma CVD apparatus.

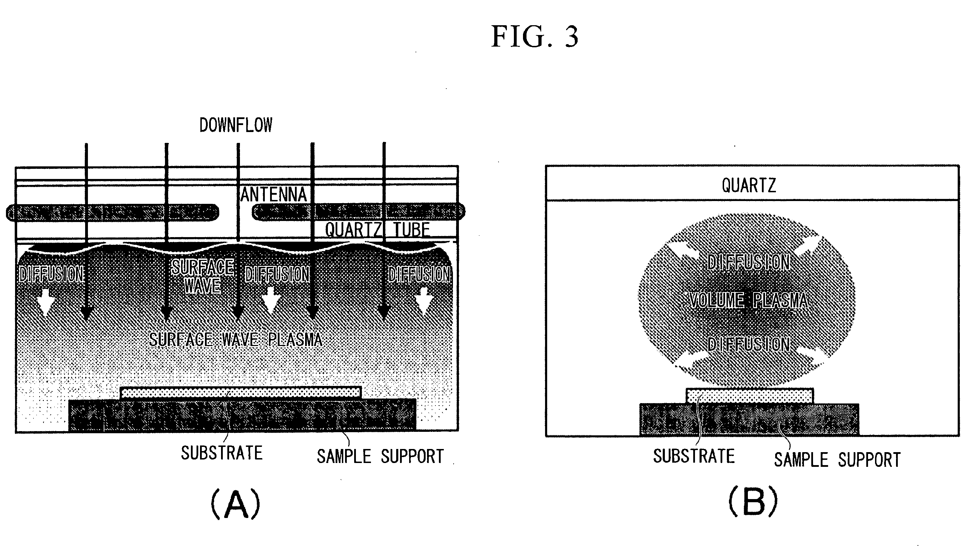

The structure of a reactor is illustrated in FIG 3 (A). The carbon film of the present invention can be produced by mainly employing a specific apparatus under specific conditions. For producing the carbon film, it is necessary to use a surface wave plasma generating apparatus capable of forming a film with a large area. Further, this apparatus is provided with a gas downflow device which supplies an amorphous substance for suppressing generation of impurities such as amorphous carbon or graphite accompanied by formation of the carbon grains and/or for suppressing growth of the carbon grains, as well as source gases of the carbon grains such as a carbon-containing gas, a hydrogen gas, and a carbon dioxide gas if necessary, toward a substrate within a chamber.

In the apparatus illustrated in FIG 3 (A), as a dielectric material for covering an antenna, a quartz tube is used. Such a quartz tube plays an important role as a supply source of $SiO_2$ and/or Si raw materials, which are the amorphous substance for suppressing the generation of impurities such as amorphous carbon or graphite accompanied by the formation of the carbon grains and/or for suppressing the growth of the carbon grains.

Specifically, when the quartz is exposed to the source gases plasmarized by microwaves, a Si gas and an oxygen gas are generated, and are plasmarized together with the source gases. Such plasma has a higher density as it is closer to the quartz tube. The plasma is diffused in substantially the substrate direction. The Si gas and the oxygen gas diffuse and flow downwardly together with the source gases so as to be effectively supplied to the substrate. This supplying is controlled by adjusting the gas pressure within the CVD chamber to control the plasma density so as to control the generation ratio of the Si gas and the oxygen gas. As explained above is the fundamental method of the carbon film depositing apparatus according to the present invention illustrated in FIG. 3(A), which uses a mechanism for very effectively supplying the surface wave plasma to the substrate by combining the surface wave plasma with the downflow. On the other hand, the configuration of a conventional CVD treatment apparatus is illustrated in FIG. 3(B). In the conventional apparatus, plasma is generated at substantially the center portion of the CVD chamber and diffuses in all directions. Therefore, the efficiency of the plasma reaching the substrate is extremely poor, as compared to the carbon film depositing apparatus according to the present invention.

In the apparatus illustrated in FIG. 3(A), Si and $SiO_2$ have been exemplified as the examples of the amorphous substance for suppressing the generation of impurities such as amorphous carbon and graphite accompanied by the formation of the carbon grains and/or for suppressing the growth of the carbon grains. However, the amorphous substance usable in the present invention is not limited thereto and a substance exhibiting the same property such as Ti, $TiO_2$, $HfO_2$, or ZnO can be used.

As described below, it is desirable that the furnace temperature (temperature of the atmosphere inside the furnace) be low, preferably in the range from room temperature to 600°C, and more preferably in the range from 100°C to 450°C, so that this amorphous substance is deposited and coated on the grain boundary between the carbon grains and/or the gap between the carbon grains with high density. When the temperature was outside the above-mentioned range, formation of the amorphous substances Si and/or $SiO_2$ were not confirmed. The formation of the amorphous substances and the mechanism of Si and/or $SiO_2$ are as follows. As the temperature is low, Si which is likely to be melted into the carbon grains when the carbon grains are formed is deposited as the amorphous substance Si on the surface of the carbon grains. Si deposited on the surface is deposited on the surface of the grains i.e., the grain boundaries between the carbon grains and/or the gaps between the carbon grains. Alternatively, Si is oxidized by oxygen in the plasma to be deposited and coated as the amorphous substance $SiO_2$. Until now, formation of an amorphous substance such as Si and/or $SiO_2$ by a CVD treatment at a temperature as low as room temperature has been confirmed.

In the present invention, for subjecting a glass substrate to a CVD treatment, it is necessary to perform the CVD treatment at a temperature lower than the distortion point of the glass substrate. Since a typical CVD treatment of diamond is performed under a pressure of $2 \times 10^3$ to $1 \times 10^4$ Pa, the temperature of the glass substrate becomes 800°C or higher. Therefore, a typical CVD treatment cannot be applied to a glass substrate. For lowering the temperature, it is necessary to perform the plasma treatment under a low pressure.

For this reason, in the present invention, surface wave plasma is generated under a pressure of about $1 \times 10^2$ Pa and utilized in the CVD treatment. The surface wave plasma is described in detail in, for example, "Hideo Sugai, Plasma Electronics pp. 124 and 125 published in 2000 by Ohmusha, Ltd.". As a result, it became possible to perform the CVD treatment of the glass substrate at a temperature lower than the distortion point of the glass substrate. Moreover, it became possible to generate uniform plasma onto a surface as large as 380 mm $\times$ 340 mm or more. Such plasma was evaluated by a Langmuir probe (single probe), and the plasma density was found to be $8 \times 10^{11}/cm^3$. This plasma density exceeds the critical plasma density of $7.4 \times 10^{10}/cm^3$, which is the requirement of surface wave plasma by microwaves having a frequency of 2.45 GHz. The Langmuir probe method is described in detail in, for example, "Hideo Sugai, Plasma Electronics p. 58 published in 2000 by Ohmusha, Ltd.".

With respect to the CVD treatment conditions used in the present invention, the temperature is in the range from room temperature to 600°C, and preferably in the range from 100°C to 450°C, and the pressure is preferably in the range from $5 \times 10^1$ Pa to $5 \times 10^2$ Pa, and more preferably in the range from $1.0 \times 10^2$ Pa to $1.2 \times 10^2$ Pa. The treatment time is in the range from 0.5 hour to 20 hours, and generally in the range from 1 hour to 8 hours. By the above-mentioned treatment time, it becomes possible to obtain a film thickness of about 100 nm to 2 $\mu$m.

The source gas (reaction gas) used to perform the CVD treatment is a mixture gas composed of a carbon-containing gas and hydrogen. Examples of the carbon-containing gas include methane, ethanol, acetone, and methanol. In the carbon-containing gas/ hydrogen mixture gas, the concentration of the carbon-containing gas is in the range from 0.5 mol% to 10 mol%, and preferably in the range from 1 mol% to 4 mol%. If the carbon-containing gas becomes larger than the above-mentioned range, a problem may arise in that transmittance is lowered, which is not desirable.

Further, as an additive gas for forming amorphous substance, an amorphous substance forming gas such as a silicon-containing gas including silane or disilane, or a gas containing metals such as titanium, hafnium, and zinc is added to the above-mentioned mixture gas.

These gases function as an amorphous source for suppressing generation of impurities such as amorphous carbon or graphite accompanied by the formation of the carbon grains and/or for suppressing growth of the carbon grains.

The amount of the amorphous substance forming gas (such as silane and/or disilane) within the mixture gas is preferably in the range from 0.1 mol% to 10 mol%, and more preferably in the range from 0.5 mol% to 2 mol%.

Further, as an additive gas, it is preferable that $CO_2$ and/or CO be added to the mixture gas. Such a gas functions as an oxygen source and removes impurities in the CVD treatment.

The amount of $CO_2$ and/or CO within the mixture gas is preferably in the range from 0.5 mol% to 10 mol% of the entire mixture gas, and more preferably in the range from 1 mol% to 4 mol%.

In the present invention, when the glass substrate is subjected to the CVD treatment, in consideration of the adhesion between the glass substrate and the synthesized carbon film, the CVD treatment temperature (substrate temperature) is appropriately adjusted to a temperature lower than the distortion point of the glass, and preferably a temperature of about 300°C to 450°C. For example, when a soda lime glass substrate is used, since the distortion point thereof is at about 470°C, the CVD treatment temperature is a temperature lower than the distortion point, and preferably a temperature from room temperature to 450°C. Alternatively, when a borosilicate glass such as Pyrex (registered trademark) or the like is used, the CVD treatment temperature is preferably in the range from room temperature to 550°C, and more preferably in the range from 100°C to 450°C.

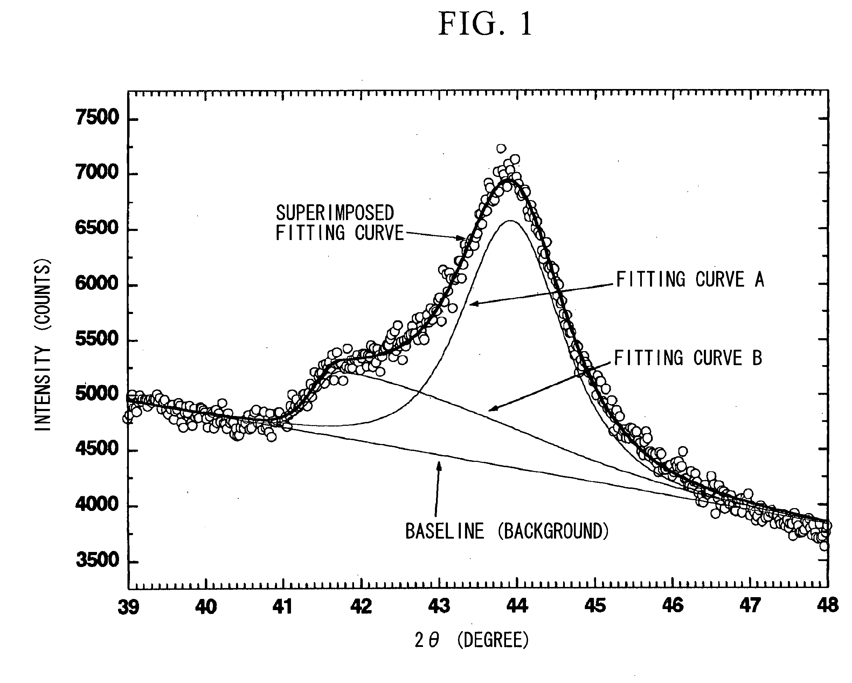

According to the present invention, the carbon grains or the carbon film can be formed on a glass substrate. The carbon grains and the carbon film have a remarkable characteristic different from other carbon grains and carbon films such as diamond in that they have an approximate spectrum curve obtainable by superimposing a peak fitting curve B at a Bragg angle ($2\theta \pm 0.5°$) of $41.7 \pm 0.5°$ and a baseline on a peak fitting curve A at a Bragg angle ($2\theta \pm 0.5°$) of 43.9° in an X-ray diffraction spectrum by a Cuk$\alpha_1$ ray, as shown in Fig. 1.

Further, in a Raman scattering spectrum (excitation light wavelength: 244 nm), a distinct peak is clearly observed near a Raman shift of 1333 cm$^{-1}$ and the full width at half maximum (FWHM) thereof is in the range from 10 cm$^{-1}$ to 40 cm$^{-1}$.

Furthermore, the film is excellent in flatness and adhesion and the surface roughness Ra is 20 nm or less. In some cases, the film is extremely flat to exhibit a surface roughness Ra of 3 nm or less. Still further, the film has excellent optical characteristics, such as excellent transparency, a refractive index as high as 2.1 or more, and hardly any birefringence. Still further, the film has an excellent electrical property. Specifically, the film exhibits an extremely high electric insulating property, such that the electrical resistivity is as high as 10$^7$ $\Omega$cm or more at 100°C.

When the cross-sectional surface of the film was observed with a high-resolution transmission electron microscope, the following characteristics were confirmed. Crystalline carbon grains having a grain size in the range from 1 nm to several tens of nm are closely formed without gaps. Further, the grain size distribution does not vary (that is, the average grain size is almost the same) at the interface between the film and the substrate, within the film and in the vicinity of the outermost surface of the film. The thickness of the carbon film is preferably in the range from 2 nm to 100 $\mu$m, and more preferably in the range from 50 nm to 500 nm. The grain size of the grains is preferably in the range from 1 nm to 100 nm, and more preferably in the range from 2 nm to 20 nm.

The cross-sectional surface of the film was thinned by ion milling, and the film structure and element distribution were observed by a high-resolution transmission electron microscope and electron energy loss spectroscopy (EELS). With respect to various points within the film, an EELS spectrum was observed in a region of approximately 100 nm. As a result, Si was observed in all of the observed points. Further, it was confirmed that the amount of Si varies depending on the observed point.

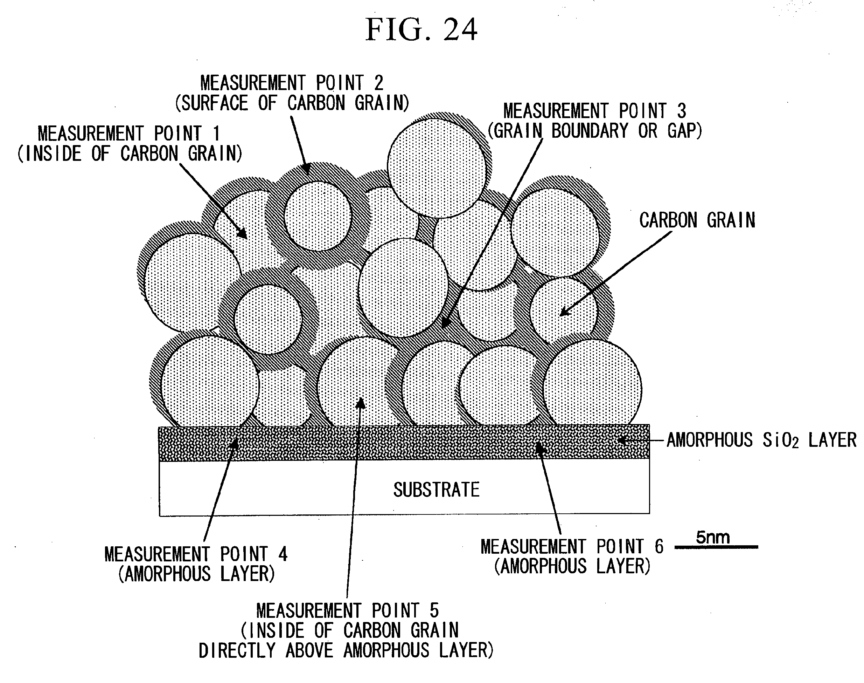

Further, for investigating the element distribution in a micro-region, a detailed EELS measurement was performed, and a detailed analysis of the spectrum was performed. In the EELS spectrum, a peak ascribed to Si (silicon) in the vicinity of 120 eV, a signal ascribed to C (carbon) in the vicinity of 300 eV and a signal ascribed to O (oxygen) in the vicinity of 530 eV were significant, and hence, attention was directed to these peak and signals. FIG 24 is a schematic view illustrating the photomicrograph of a measured sample taken by a high-resolution transmission electron microscope. Measurement Point 1 is the inside of a single carbon grain. Measurement Point 2 is a grain boundary. Measurement Point 3 is a portion where the carbon grain does not exist, which is rarely observed within the film.

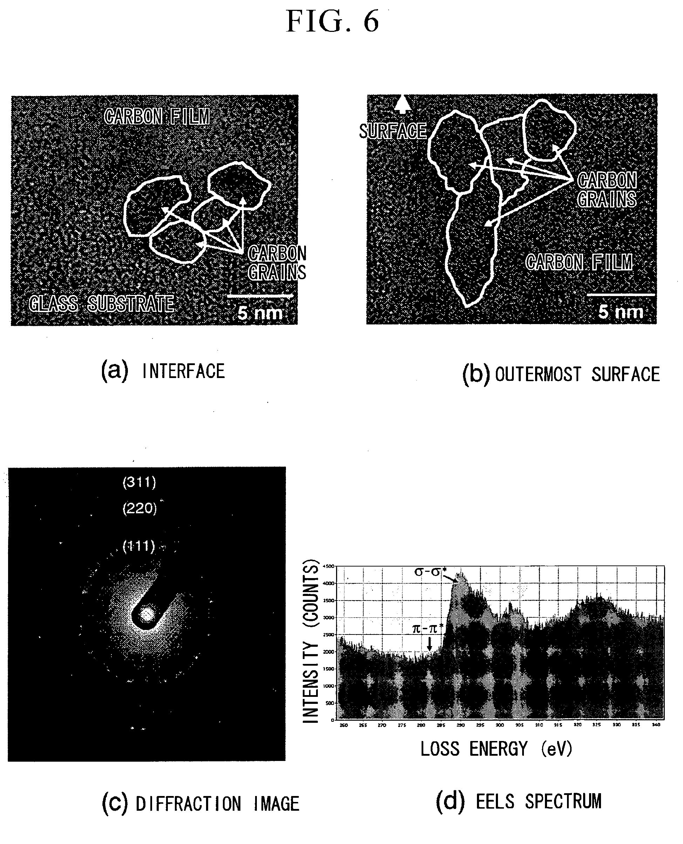

From the shape of the peak in the EELS spectrum, Si which is not SiO$_2$, and C exist at Measurement Point 1, SiO$_2$ and C exist at Measurement Point 2, and SiO$_2$ and C exist at Measurement Point 3. Therefore, in the carbon film according to the present invention, it was confirmed that SiO$_2$ exists on the surface of the carbon grains forming the film, and more preferably, SiO$_2$ is formed so as to surround the carbon grains. In the diffraction image illustrated in FIG. 6(c), a diffraction ring indicating the existence of crystalline SiO$_2$ was not observed. Therefore, it was confirmed that SiO$_2$ exists as amorphous SiO$_2$ within the carbon film. In the carbon film according to the present invention, amorphous SiO$_2$ exists on the surface of the carbon grains forming the film, and preferably exists to surround the carbon grains. This characteristic distribution of the amorphous SiO$_2$ has been realized for the first time by the technique of the present invention. Such a characteristic distribution was not observed in a conventional diamond, a diamond-like carbon film, or the like.

The amorphous SiO$_2$ plays an extremely important role in functioning as a substance for suppressing generation of impurities such as amorphous carbon or graphite accompanied by formation of the carbon grains and/or for suppressing growth of the carbon grains.

It was confirmed that an amorphous layer was formed in a region of about 10 nm directly above the substrate. In FIG 24, the amorphous layer (Measurement Points 4 and 6) directly above the substrate was formed of SiO$_2$ and C. In addition, Si other than SiO$_2$ and C existed within the grains directly above the amorphous layer (Measurement Point 5). According to the method of the present invention, an amorphous SiO$_2$ layer is formed directly above the substrate, and a carbon film layer is formed on the amorphous SiO$_2$ layer. Such a method and effects thereof are realized in the following manner. Source gases including a carbon-containing gas, a hydrogen gas, and a silicon-containing are uniformly supplied toward the chamber in a downflow manner to generate plasma. Further, by using a substrate temperature of preferably 600°C or lower, and more preferably 450°C or lower, SiO$_2$, which is deposited more easily than the carbon film at a low temperature, can be deposited on the substrate surface prior to the carbon film. Finally, the carbon film is deposited on the surface of the $SiO_2$ layer. This is one of the most significant effects of the present invention.

The $SiO_2$ layer existing between the substrate and the carbon film serves as an adhesion-reinforcing layer for enhancing adhesion between the substrate and the carbon film. Especially with respect to a substrate such as copper, iron, or tungsten carbide to which a carbon film cannot be directly deposited, or which exhibits a considerably weak adhesion and various capabilities of the carbon film cannot be utilized even if the carbon film is deposited, this technique according to the present invention is considerably simpler and more practical, as compared to a conventional technique of forming an adhesion-reinforcing layer for enhancing adhesion by a conventional process. Furthermore, by the method of the present invention, the adhesion-reinforcing layer and the carbon film can be deposited by the same process. Therefore, adhesion can be considerably improved, as compared to the conventional method.

FIG. 25 is a diagram illustrating the structure of this film observed by the high-resolution transmission electron microscope and the electron energy loss spectroscopy. Firstly, the adhesion-reinforcing layer which is the amorphous $SiO_2$ is deposited on the substrate. Subsequently, carbon grains are formed, and the carbon film is deposited. In the grain boundaries between the carbon grains forming the carbon film and/or the gaps between the carbon grains, there exist Si and/or $SiO_2$ which exhibit effects of suppressing generation of impurities such as amorphous carbon or graphite accompanied by the formation of the carbon grains and/or suppressing growth of the carbon grains.

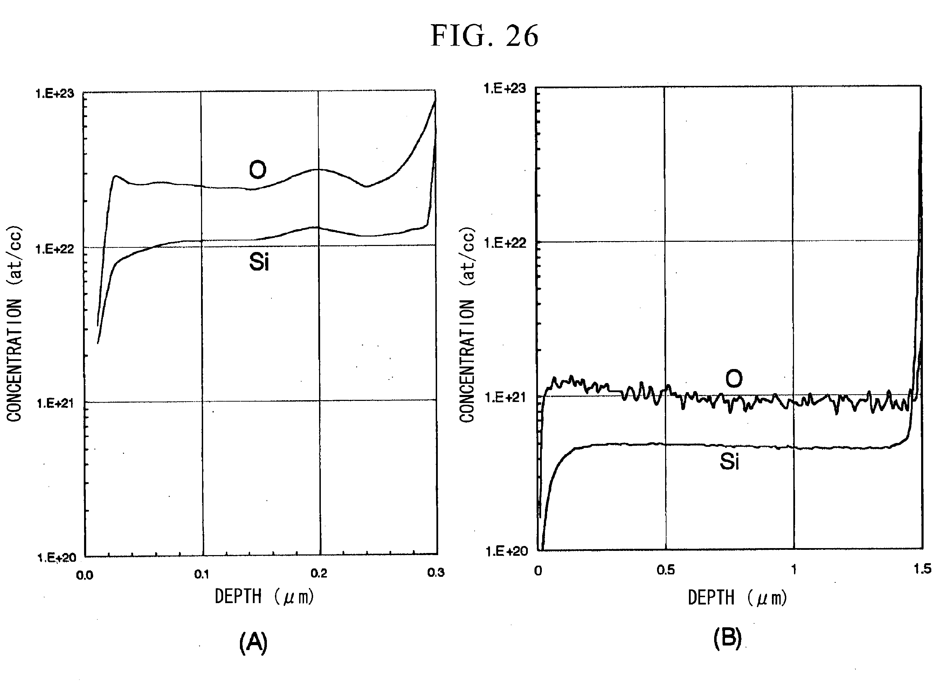

For investigating how much of the amorphous $SiO_2$ exhibiting the above-described effects was taken into the carbon film, the concentration of silicon and oxygen within the film was measured by secondary ion mass spectroscopy (SIMS). FIG. 26 is a diagram illustrating distribution of silicon (Si) and oxygen (O) contained in the carbon film according to the invention in the depth-wise direction of the film, as measured by SIMS. The difference in formation conditions of the carbon films illustrated in FIGs. 26(A) and 26(B) is the areas of the dielectric material (quartz) covering an antenna which serves as a supply source of raw materials for forming the amorphous $SiO_2$. Therefore, in the carbon film of FIG. 26(A), the amount of the source gas for forming amorphous $SiO_2$ supplied from the dielectric material (quartz) covering the antenna was 10 to 20 times of the source gas in the carbon film of FIG. 26(B).

The silicon content and the oxygen content in the vicinity (0.16 $\mu$m) of the center of the thicknesswise direction of the carbon film of FIG. 26(A) were $1.2 \times 10^{22}/cm^3$ and $2.5 \times 10^{22}/cm^3$, respectively. Therefore, it was confirmed that the ratio of the silicon content to the oxygen content was approximately 1:2, and silicon and oxygen existed in the form of $SiO_2$ within the carbon film. Further, the density of the film was approximately $1.8 \times 10^{23}/cm^3$, and hence, the average concentration of $SiO_2$ within the film was approximately 6.7%. On the other hand, in the carbon film of FIG. 26(B) in which supply of the source gases for forming the amorphous $SiO_2$ was 1/10 to 1/20 of that in the carbon film of FIG. 26 (A), the silicon content and the oxygen content in the vicinity (0.74 $\mu$m) of the center of the thicknesswise direction of the film were $4.8 \times 10^{20}/cm^3$ and $9.3 \times 10^{20}/cm^3$, respectively. Therefore, in the carbon film of FIG. 26(B), it was also confirmed that the ratio of the silicon content to the oxygen content was approximately 1:2, and silicon and oxygen existed in the form of $SiO_2$ within the carbon film. Further, it was confirmed that the average concentration of $SiO_2$ within the carbon film in FIG. 26(B) was approximately 0.27 at%.

From the above, it was confirmed that the carbon film of FIG. 26(A) contained nearly 25 times of $SiO_2$ as that of the carbon film of FIG. 26(B). In this manner, the content of $SiO_2$ within the carbon film could be controlled by adjusting the supply of the source gas for forming the amorphous $SiO_2$. In the present invention, it was confirmed that the content of $SiO_2$ within the carbon film can be appropriately controlled in the range from about 0.1 at% to 10 at% in the above-described manner. Furthermore, since the carbon film depositing apparatus according to the present invention is capable of reducing the supply of the source gas for forming the amorphous $SiO_2$, it becomes possible to control the content of $SiO_2$ within the carbon film in the range from about 0.01 at% to 10 at%.

EXAMPLES

As follows is a description of examples of the present invention, although the scope of the present invention is by no way limited by these examples.

As a substrate, glass (borosilicate glass and soda lime glass) cut out with a size of 300 mm $\times$ 300 mm was used. Further, for producing a sample to be evaluated, a wafer-like glass substrate with a 4-inch diameter was also used. For increasing the nucleus formation density of the carbon grains to thereby form a uniform film, the substrate was subjected to a pretreatment (treatment of adhering nano crystal diamond grains) prior to formation of a film.

In this pretreatment, a colloidal solution (product name: Nanoamand, manufactured by NanoCarbon Research Institute Co., Ltd) in which nano-crystal diamond grains having an average grain size of 5 mm were dispersed in pure water, a solution in which nano-crystal diamond grains of an average grain size of 30 nm or 40 nm (products name: MD30 and MD40 respectively, manufactured by Tomei Diamond Co. Ltd.) were dispersed in pure water, ethanol in which cluster diamond grains or graphite cluster diamond grains (products name: CD and GCD, respectively; manufactured by Tokyo Diamond Tools Mfg. Co.) were dispersed, or a solution of adamantane, derivatives thereof, or multimeric compounds thereof (manufactured by Idemitsu Kosan Co., Ltd.) was used, and a substrate was immersed therein and treated with a supersonic cleaning apparatus.

Subsequently, the substrate was immersed in ethanol, subjected to supersonic cleaning and dried, or the solution was uniformly applied onto the substrate by spin coating and dried. The uniformity achieved by the pretreatment affects the uniformity of the formed carbon film. In this case, the number of diamond grains adhered to the substrate was from $10^{10}$ to $10^{11}$ per 1 cm$^2$.

As a source gas, $CH_4$, $CO_2$, silane, and $H_2$ were used, and the concentrations of $CH_4$, $CO_2$ and silane were each set at 1 mol%. The gas pressure within the reaction vessel was set at 1.0 to 1.2 $\times$ 10$^2$ Pa (1.0 to 1.2 mbar) which is lower than the pressure used for a typical CVD synthesis of diamond (10$^3$ to 10$^4$ Pa), and microwave of 20 to 24 kW in total were charged to generate uniform plasma for an area larger than the substrate area (300 $\times$ 300 mm$^2$). At this time, by closely contacting a Mo sample support with a cooling stage and adjusting the distance between the substrate and the antenna, it became possible to maintain the substrate temperature at 450 °C or lower, which is the softening point of soda lime glass, during film formation.

Film formation was performed for 6 to 20 hours under the above-described film forming conditions. A uniform and transparent carbon film was formed on the glass substrate after film formation. The thickness of the film was in the range from 300 nm to 2 $\mu$m.

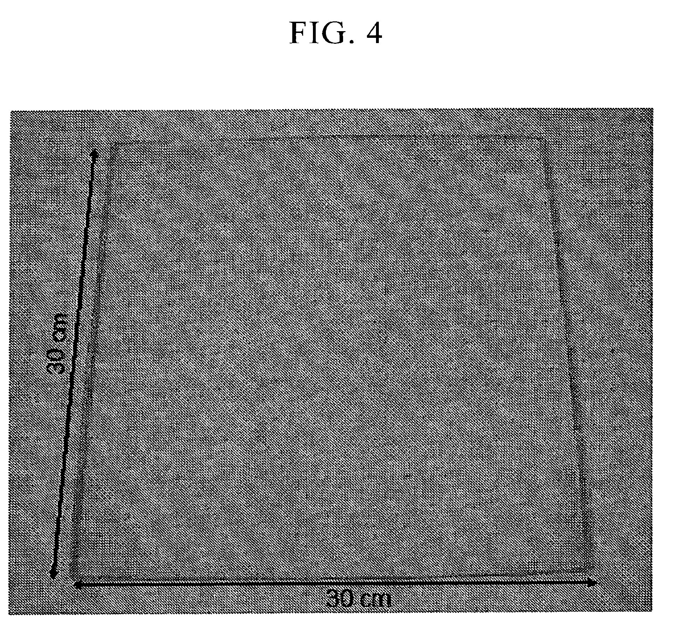

FIG. 4 shows an overall photograph of the carbon film according to the invention formed on the glass substrate of 300 mm $\times$ 300 mm. In FIG. 4, the substrate appears as if it was distorted because of the function of the camera, but the substrate was not actually distorted. The film had a thickness of about 400 nm and is extremely transparent, but presence of the film could be confirmed by interference color.

The carbon film was observed by X-ray diffraction. The measurement will be described below in detail. The X-ray diffraction apparatus used was an X-ray diffraction measurement apparatus RINT2100 XRD-DSCII manufactured by Rigaku Corporation, and the goniometer used was Ultima III horizontal goniometer manufactured by Rigaku Corporation. A multi-purpose sample support for thin film standard was attached to the goniometer. The measured sample was a carbon film having a thickness of 500 nm formed on a borosilicate glass substrate having a thickness of 1 mm by the above-described method. The measurement was performed with respect to a piece cut out with a size of 30 mm square together with the glass substrate. As X-ray, copper (Cu)K$\alpha_1$ ray was used. The voltage and current applied to the X-ray tube were 40 kV and 40 mA, respectively. A scintillation counter was used as an X-ray detector. First, calibration of the scattering angle (2θ angle) was conducted by using a standard silicon sample. Deviation of 2θ angle was no more than +0.02°. Then, the sample to be measured was fixed to the sample support, and the 2θ angle was adjusted to 0°, i.e. a condition under which X-ray directly entered the detector. The X-ray incident direction and the sample surface were adjusted to be in parallel, and a half of the incident X-ray was shielded by the sample. The goniometer was rotated from this state and X-ray was irradiated at an angle of 0.5° relative to the sample surface. The 2θ angle was rotated by 0.02° from 10° to 90° while fixing the incident angle, and the intensities of X-ray scattering from the sample at respective 2θ angles were measured. The computer program used for the measurement was RINT2000/PC software Windows version (registered trademark) manufactured by Rigaku Corporation.

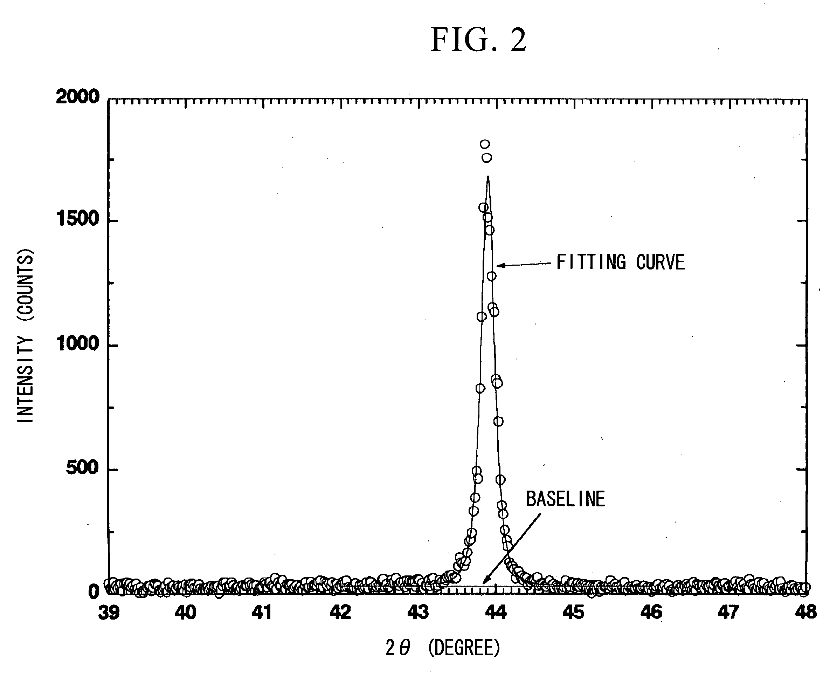

A spectrum of the measured X-ray diffraction is shown in FIG 1. White circles in the drawing are measuring points. It can be seen that a distinct peak is present at a 2θ of 43.9°. As shown in FIG 1, it is interesting that the peak at 43.9° has a shoulder at 2θ in the range from 41° to 42° on the lower side angle thereof (with respect to the term "shoulder" of the spectrum, see "Kagaku Daijiten (Chemical Encyclopedia)" (Tokyo Kagaku Dojin)). Therefore, the peak is composed of two component peaks including a peak (first peak) around 43.9° as the center and another peak (second peak) distributed around 41° to 42°. In X-ray diffraction by CuK$\alpha_1$ ray, diamond has been known as a carbon-based substance having a peak at 2θ of 43.9°. FIG. 2 is a diagram illustrating a spectrum of an X-ray diffraction measured with respect to diamond by the same method as described above, and the peak is ascribed to (111) reflection of diamond. The difference in the X-diffraction spectrum between the carbon film of the present invention and diamond is apparent, and the second peak distributed in the range from about 41° to 42° shown in the spectrum of the carbon film of the invention cannot be seen in diamond. Thus, (111) reflection of diamond consists of 1 component (the first peak) at 43.9° as the center, and a shoulder on the lower side angle as in the carbon film according to the invention is not observed. Therefore, the second peak distributed in the range from about 41° to 42° observed in the spectrum of the carbon film according to the present invention is a peak inherent to the carbon film according to the present invention.

Meanwhile, it could be seen that the peak for the X-ray diffraction spectrum of the carbon film according to the present invention in FIG. 1 is significantly broad, as compared to the peak of diamond in FIG. 2. In general, when the size of grains composing the film decreases, the width of the X-ray diffraction peak becomes broad. Therefore, the size of the grains composing the carbon film of the invention can be said to be considerably small. As a result of an estimation of the size of the carbon grains composing the carbon film according to the present invention (average diameter), based on the width of the peak according to Sherrer's formula (which is generally used in X-ray diffraction), it was found that the size of the carbon grains was about 15 nm. With respect to Sherrer's formula, see, for example, "Hakumaku (Thin Film) Handbook, edited by Japan Society for the Promotion of Science, Thin Film, 131 st Committee, from Ohmusha Ltd., in 1983, p. 375".

Next, the constitution of the peaks (positions and strength for respective peak components) will be described in detail.

In order to analyze the detailed constitution of the peak at 2θ of 43.9° in the X-ray diffraction measurement for the carbon film according to the present invention, analysis was carried out with respect to the 2θ angle in the range from 39° to 48° by using peak fitting. For the fitting of the first peak, a function called Pearson VII function was used. The function is used most generally for representing the profile of a peak obtained in a diffraction method such as X-ray diffraction or neutron diffraction. With respect to the Pearson VII function, see, for example, "Introduction Practice of Powder X-ray Analysis-Introduction to Rietveld Method" (edited by X-ray Analysis Study Conference of Japan Society for Analytical Chemistry, Asakura Shoten, Asakura Publishing Ltd.). On the other hand, as a result of study of various functions, it was found that an asymmetric function can be preferably used for the fitting of the second peak. In this example, an asymmetric normal distribution function (Gaussian distribution function) was used. This function is a normal distribution function having different dispersion (standard deviation) values on the right-hand side and the left-hand side of the peak position, and is one of the simplest functions as a function used for the fitting of an asymmetric peak. Nevertheless, the peak fitting could be performed favorably. Further, a linear function was used as a base line (background) function.

In the actual fitting operation, various computer programs can be used. In this example, ORIGIN version 6, peak fitting module Japanese edition (hereinafter referred to as ORIGIN-PFM) was used. In ORIGIN-PFM, the Pearson VII function is represented as "Pearson 7", the asymmetric normal distribution function is represented as "BiGauss", and the linear function is represented as "Line". The completion requirement for the fitting was defined that the correlation coefficient ("COR", or "Corr Coef" in ORIGIN-PFM) representing the reliability of the fitting was 0.99 or more.

According to the analysis using the peak fitting, as shown in FIG. 1, it can be seen that the measured spectrum could be well approximated as the sum (superimposed fitting curve in the drawing) of the first peak (fitting curve A in the drawing) according to the Pearson VII function, a second peak (fitting curve B in the drawing) according to the asymmetric normal distribution function and the base line (background) according to the linear function. In the measurement, the center of the fitting curve A was at 2θ of 43.9°, whereas the fitting curve B became a maximum at 41.7°. Areas surrounded by respective fitting curves and the base line are the respective peak intensities. Using these areas, the intensity of the second peak based on the intensity of the first peak was analyzed. In this example, the intensity of the second peak (fitting curve B) was 45.8% of the intensity of the first peak (fitting curve A).

X-ray diffraction measurement was performed with respect to many samples of the carbon film according to the present invention. As a result, it was found that a peak with a broad width as shown in FIG. 1 was observed around 2θ of 43.9° with respect to all of the samples. Furthermore, each of the peaks had a shoulder on the lower angle side as shown in FIG. 1, and was composed of the first peak and the second peak. With respect to each of the samples, analysis was carried out by peak fitting of X-ray diffraction spectrum in the same manner. As a result, it was found that the fitting could be carried our extremely well by using the above-described functions. Specifically, the center of the first peak was at 2θ of 43.9° ± 0.3°. Further, it was found that the second peak became a maximum at 20 of 41.7° ± 0.5°. The intensity ratio of the second peak to the first peak was at a minimum 5% and at a maximum 90%. The intensity ratio largely depends on the synthesis temperature and it tended to increase as the temperature became lower. On the other hand, the peak position was nearly constant, irrespective of the synthesis temperature.

In the analysis method of measuring the X-ray diffraction, it should be noted that fluctuation in the measurement data becomes large when the intensity of the X-ray is small, and hence, a reliable fitting becomes impossible. For this reason, it is necessary to carry out the analysis by the above-described fitting with respect to those having a maximum peak intensity of 5,000 counts or more.

As described above, it became apparent that the carbon film according to the present invention has a broad peak around 2θ of 43.9° as the center in the measurement of X-ray diffraction by $CuK\alpha_1$ rays, and that the peak has a shoulder on the lower angle side. By the analysis using the peak fitting, it was found that the peak could be well approximated by superimposing a first peak according to a Pearson VII function having a center at 2θ of 43.9°, a second peak according to an asymmetric normal distribution function being maximum at 41.7°, and a base line according to a linear function (background).

Analysis by peak fitting was carried out in the same manner for the spectrum of diamond shown in FIG. 2. Unlike the carbon film of the present invention described above, in the case of diamond, it was found that the peak could be well approximated only with the Pearson VII function having a center at 2θ of 43.9°. As a result, it was found that the carbon film of the present invention is a substance having a structure different from that of diamond.

The carbon film according to the present invention has a characteristic in that the above-described second peak is observed, and has a structure different from that of diamond. The production steps of the carbon film according to the present invention and the result of other measurements were investigated and the structure was studied. The synthesis method of the carbon film used in the present invention has the following remarkable characteristic, as compared to the CVD synthesis method of diamond. Firstly, a typical synthesis of diamond has been carried out at a temperature of at least 700°C or higher, whereas the carbon film according to the present invention is synthesized at a considerably low temperature. Further, for reducing the grain size of a diamond film, a method in which a rapid growth is performed at a high carbon source concentration (molar ratio of methane gas) contained within the source gas of about 10% has been conventionally used. On the other hand, in the present invention, the carbon source concentration is as low as about 1 %. That is, in the method of the present invention, carbon grains are deposited at a low temperature considerably slowly over a long period to form a film. As a result, the carbon grains are deposited in a state where they are almost transformed into diamond. Therefore, a force of promoting deposition of hexagonal diamond (which is carbon crystals more stable than the typical cubic diamond) or deposition of more stable graphite is acted, and hence, it is extremely unstable as the state of crystal deposition. Further, deposited graphite and amorphous carbon-based substance are removed by etching with an excess amount of hydrogen plasma contained in the source gas. By such a deposition mechanism, carbon grains form a structure in which cubic diamond and hexagonal diamond are mixed, and portions removed by etching remain as defects with a considerably high concentration. Such defects include point defects such as atomic vacancy, linear defects such as dislocation, and defects on a unit surface such as lamination defects, which are contained in large amounts. For this reason, the carbon film has a structure in which an X-ray diffraction peak at 43.9° has a shoulder on the lower side angle.

However, the characteristic of the X-ray diffraction peak described above is in association with high functions of the carbon film according to the present invention. Specifically, due to the low rate synthesis at a low carbon source concentration, etching of graphite and graphite-like substances is promoted. Consequently, although the structure contains defects at high concentration, transparency of the carbon film is maintained at a high level. Because the synthesis is performed at a low temperature, the cubic diamond and the hexagonal diamond are mixed, and defects are contained with a high concentration. However, by virtue of the low temperature, carbon can be deposited on an iron-based substrate without immersion into the iron-based substrate, and direct coating on copper becomes possible. Further, by virtue of the low temperature, the size of grains becomes uniformly fine, and hence, thermal strain is extremely small. That is, the structure in which the cubic diamond and the hexagonal diamond are mixed and defects are contained at a considerably high concentration enables the thermal strain to be reduced, thereby resulting in small optical birefringence. Likewise, due to this structure, a considerably high electric insulation property is exhibited.

A Raman scattering spectrum of the carbon film was measured. An ultraviolet excitation spectrometer, NRS-1000UV manufactured by Jasco International Co., Ltd., was used to carry out the measurement and a UV-laser (Ar ion laser 90C FreD manufactured by Coherent Inc.) at a wavelength of 244 nm was used for the excitation light. The power of the laser source was 100 mW, and a beam attenuator was not used. The aperture was set at 200 $\mu$m. The measurement was performed with an exposure time of 30 to 60 seconds twice and was integrated to obtain a spectrum. The apparatus was calibrated with single crystal diamond synthesized at high temperature and under high pressure as a standard sample for Raman scattering spectroscopy (DIAMOND WINDOW Type: DW005 for Raman, Material: SUMICRYSTAL, manufactured by Sumitomo Electric Industries Ltd). The peak position of the Raman spectrum of the standard sample was adjusted to a Raman shift of 1333 cm$^{-1}$. A standard computer software for this apparatus (Spectra Manager for Windows (registered trademark) 95/98 ver. 1.00 manufactured by Jasco International Co., Ltd.) was used to carry out the measurement and the analysis.

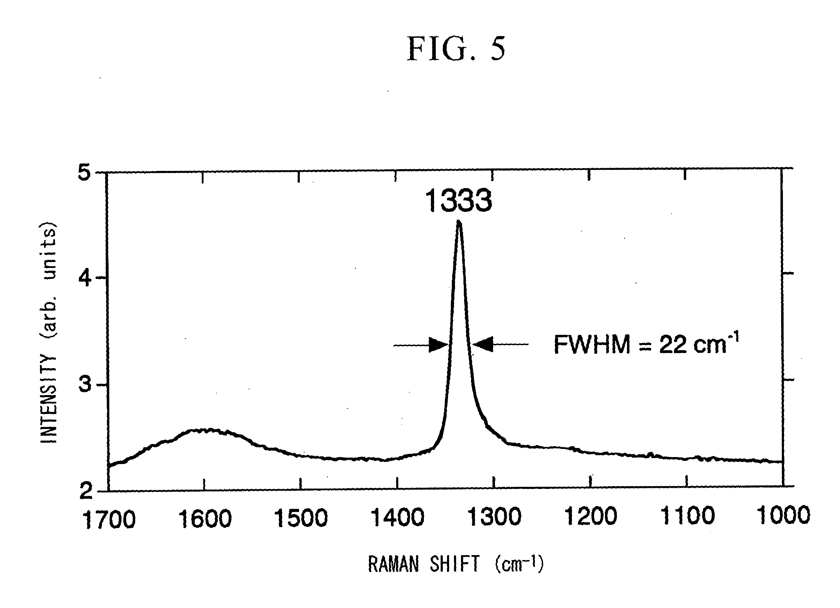

A typical measured Raman scattering spectrum is shown in FIG. 5. The measured sample is a carbon film having a thickness of about 1 $\mu$m formed on a borosilicate glass wafer having a diameter of 10 cm and a thickness of 1 mm by the above-described method. As shown in FIG. 5, a peak located near the Raman shift of 1333 cm$^{-1}$ was clearly observed in the Raman scattering spectrum of the carbon film. As a result of carrying out the measurement in the same manner for many other samples, it was found that the peak was in the range from 1320 cm$^{-1}$ to 1340 cm$^{-1}$ and always falls within the range of 1333 $\pm$ 10 cm$^{-1}$. Further, a broad peak observed near the Raman shift of 1580 cm$^{-1}$ showed the presence of the sp$^2$ bond component of carbon. As the ratio of the sp$^2$ bond component increases, the film becomes opaque to assume a black color. In the case of FIG. 5, the height of the peak of the sp$^2$ bond component was as low as about 1/7 of the peak at 1333 cm$^{-1}$ and, as shown below, it was found that the film was transparent. The Full Width at Half-Maximum (FWHM) in this case was about 22 cm$^{-1}$. As a result of the same measurement for many other samples, it was found that FWHM was in the range from 10 cm$^{-1}$ to 40 cm$^{-1}$.

The cross-sectional surface of the carbon film was observed by a high resolution transmission type electron microscope (HRTEM). The HRTEM apparatus used was H-9000 transmission electron microscope manufactured by Hitachi Ltd. and observation was carried out at an acceleration voltage of 300 kV. Further, a standard fitted sample holder for the HRTEM apparatus was used as a sample holder. The sample for observation was produced by one of the methods (1) slicing the sample by Ar ion milling treatment, (2) slicing the sample by focused ion beam (FIB) fabrication, or (3) delaminating the film surface with a diamond pen and collecting the obtained slice in a microgrid.

An example of the results of observation is shown in FIG 6. FIG 6 is a diagram illustrating an example of observation of the film cross-section formed on a glass substrate. In this case, the sample was prepared by ion milling treatment. The drawing in FIG. 6(a) is an interface between the film and the substrate; the drawing in FIG 6(b) is the outermost surface of the film; the drawing in FIG 6(c) is an electron diffraction image of the film, and the drawing in FIG. 6(d) shows the results of measurement for the electron energy loss spectral (EELS) spectrum at the absorption edge of carbon K shell of carbon grains composing the film. From the drawings of FIGs. 6(a) and 6(b), it can be seen that lattice images are observed almost on the entire surface of the film, and the film is thoroughly filled with crystalline grains with no gaps. Further, the electron beam diffraction image in the drawing of FIG. 6(c) is close to a ring pattern of randomly oriented polycrystalline diamond. However, especially in the ring corresponding to the diamond (111) face, diffraction spots not located on one ring are contained in a large amount, and these diffraction spots correspond to diffraction by a plane larger by 2 to 6% than the diamond (111) face in terms of lattice spacing. The carbon film is significantly different from the typical diamond in this regard. Moreover, in the carbon film, crystal grains having a grain size within the range from 1 nm to several tens of nm are filled without gaps, and the grain size distribution does not differ at the interface between the film and the substrate, within the film, and in the vicinity of the outermost surface of the film. In addition, it was observed that one grain is constituted by one or a plurality of crystallites. Further, it can be seen from the EELS spectrum of FIG. 6(d) that there are almost no peaks corresponding to $\pi$-$\pi$* transition showing the presence of a C-C $sp^2$ bond, but there is predominantly a peak corresponding to $\sigma$-$\sigma$* transition showing the presence of the $sp^3$ bond component. Therefore, it can be seen that the film is composed of crystalline carbon grains which form $sp^3$ bonds.

The term "crystallite" refers to a micro-crystal that can be regarded as a single crystal. In general, one grain is constituted of one or plurality of crystallites. From the result of HRTEM observation, it was found that the size (average grain size) of the carbon grains (crystallites) does not differ at the interface with the substrate, within the film, and in the outermost surface, and the size was in the range from 2 to 40 nm.

When it could be regarded that the film was constituted of grains filled with no gaps, the average grain size was calculated in accordance with the following procedures.

The average grain size was determined by taking the average of the grain size of at least 100 different grains (crystallites) in a transmission electron photomicrograph of the cross-sectional surface of a carbon film. In FIG. 6(a), a portion surrounded by a white closed curve is one grain, and the area surrounded by the closed curve is calculated as S. From the calculated value S, the grain size D was determined by the following formula:

[Formula 1]

$$D = 2\sqrt{\frac{S}{\pi}}$$

wherein $\pi$ represents the ratio of circumference.

Further, the surface density $d_s$ of the grain was determined on the basis of the average grain size of the grains by the following formula:

$$d_s = \text{unit area} / (\pi \times (\text{average grain size}/2)^2)$$

By determining the surface density of the carbon film according to the present invention in this manner, it was found that the surface density does not differ in the interface, within the film, and in the outermost surface, and is in the range from $8 \times 10^{10}$ cm$^{-2}$to $4 \times 10^{12}$cm$^{-2}$.

TEM-EELS Measurement

The cross-sectional surface of the film was thinned by an ion milling treatment to observe the film structure and element distribution with a high resolution transmission electron microscope and electron energy loss spectroscopy (EELS).

With respect to various points within the film, an EELS spectrum was observed in a region of approximately 100 nm. As a result, Si was observed in all of the observed points. Further, it was confirmed that the amount of Si varies depending on the observed point.

Further, for investigating the element distribution in a micro-region, a detailed EELS measurement was performed and a detailed analysis of the spectrum was performed. In the EELS spectrum, a peak ascribed to Si (silicon) in the vicinity of 120 eV, a signal ascribed to C (carbon) in the vicinity of 300 eV and a signal ascribed to O (oxygen) in the vicinity of 530 eV were significant, and hence, attention was directed to these peak and signals. FIG. 24 is a schematic view illustrating the photomicrograph of a measured sample taken by a high-resolution transmission electron microscope. Measurement Point 1 is the inside of a single carbon grain. Measurement Point 2 is a grain boundary. Measurement Point 3 is a portion where the carbon grain does not exist, which is rarely observed within the film.

From the shape of the peak in the EELS spectrum, it was found that Si which is not $SiO_2$, and C exist at Measurement Point 1, $SiO_2$ and C exist at Measurement Point 2, and $SiO_2$ and C exist at Measurement Point 3. Therefore, in the carbon film according to the present invention, it was confirmed that $SiO_2$ is formed so as to surround independent carbon grains. The distribution of such $SiO_2$ is observed anywhere within the film. This characteristic distribution of $SiO_2$ has been realized for the first time by the technique of the present invention. Such a characteristic distribution was not observed in a conventional diamond, a diamond-like carbon film, or the like.

This $SiO_2$ plays an extremely important role in functioning as a substance for suppressing generation of impurities such as amorphous carbon or graphite accompanied by formation of the carbon grains and/or for suppressing growth of the carbon grains.

TEM-EELS Measurement

It was confirmed that an amorphous layer was formed in a region of about 10 nm directly above the substrate. In FIG. 24, the amorphous layer (Measurement Points 4 and 6) directly above the substrate was formed of $SiO_2$ and C. In addition, Si other than $SiO_2$ and C existed within the grains directly above the amorphous layer (Measurement Point 5). According to the method of the present invention, an amorphous $SiO_2$ layer is formed directly above the substrate, and a carbon film layer is formed on the amorphous $SiO_2$ layer. Such a method and effects thereof are realized in the following manner. Source gases including a carbon-containing gas, a hydrogen gas, and a silicon-containing are uniformly supplied toward the chamber in a downflow manner to generate plasma. Further, by using a substrate temperature of preferably 600°C or lower, and more preferably 450°C or lower, $SiO_2$, which is deposited more easily than the carbon film at a low temperature, can be deposited on the substrate surface prior to the carbon film. Finally, the carbon film is deposited on the surface of the $SiO_2$ layer. This is one of the most significant effects of the present invention.

The $SiO_2$ layer existing between the substrate and the carbon film serves as an adhesion-reinforcing layer for enhancing adhesion between the substrate and the carbon film. Especially with respect to a substrate such as copper, iron, or tungsten carbide to which a carbon film cannot be directly deposited, or which exhibits a considerably weak adhesion and various capabilities of the carbon film cannot be utilized even if the carbon film is deposited, this technique according to the present invention is considerably simpler and more practical, as compared to a conventional technique of forming an adhesion-reinforcing layer for enhancing adhesion by a conventional process. Furthermore, by the method of the invention, the adhesion-reinforcing layer and the carbon film can be deposited by the same process. Therefore, adhesion can be considerably improved, as compared to the conventional method.

Film Structure

FIG. 25 is a diagram illustrating the structure of this film observed by the high-resolution transmission electron microscope and the electron energy loss spectroscopy. Firstly, the adhesion-reinforcing layer which is the amorphous $SiO_2$ was deposited on the substrate. Subsequently, carbon grains were formed, and the carbon film was deposited. In the grain boundaries between the carbon grains forming the carbon film and/or the gaps between the carbon grains, there existed Si and $SiO_2$ which exhibit effects of suppressing generation of impurities such as amorphous carbon or graphite accompanied by the formation of the carbon grains and/or suppressing growth of the carbon grains.

For investigating how much of the amorphous $SiO_2$ exhibiting the above-described effects was taken into the carbon film, the concentration of silicon and oxygen within the film was measured by secondary ion mass spectroscopy (SIMS). FIG. 26 is a diagram illustrating distribution of silicon (Si) and oxygen (O) contained in the carbon film according to the invention in the depth-wise direction of the film, as measured by SIMS. The difference in formation conditions of the carbon films illustrated in FIGs. 26(A) and 26(B) is the areas of the dielectric material (quartz) covering an antenna which serves as a supply source of raw materials for forming the amorphous $SiO_2$. Therefore, in the carbon film of FIG. 26(A), the amount of the source gas for forming amorphous $SiO_2$ supplied from the dielectric material (quartz) covering the antenna was 10 to 20 times of the source gas in the carbon film of FIG. 26(B).

The silicon content and the oxygen content in the vicinity (0.16 $\mu$m) of the center of the thicknesswise direction of the carbon film of FIG 26(A) were $1.2 \times 10^{22}/cm^3$ and $2.5 \times 10^{22}/cm^3$, respectively. Therefore, it was confirmed that the ratio of the silicon content to the oxygen content was approximately 1:2, and silicon and oxygen existed in the form of $SiO_2$ within the carbon film. Further, the density of the film was approximately $1.8 \times 10^{23}/cm^3$, and hence, the average concentration of $SiO_2$ within the film was approximately 6.7%. On the other hand, in the carbon film of FIG. 26(B) in which supply of the source gases for forming the amorphous $SiO_2$ was 1/10 to 1/20 of that in the carbon film of FIG. 26(A), the silicon content and the oxygen content in the vicinity (0.74 $\mu$m) of the center of the thicknesswise direction of the film were $4.8 \times 10^{20}/cm^3$ and $9.3 \times 10^{20}/cm^3$, respectively. Therefore, in the carbon film of FIG. 26(B), it was also confirmed that the ratio of the silicon content to the oxygen content was approximately 1:2, and silicon and oxygen existed in the form of $SiO_2$ within the carbon film. Further, it was confirmed that the average concentration of $SiO_2$ within the carbon film in FIG 26(B) was approximately 0.27 at%.

From the above, it was confirmed that the carbon film of FIG 26(A) contained nearly 25 times of $SiO_2$ as that of the carbon film of FIG. 26(B). In this manner, the content of $SiO_2$ within the carbon film could be controlled by adjusting the supply of the source gas for forming the amorphous $SiO_2$. In the present invention, it was confirmed that the content of $SiO_2$ within the carbon film can be appropriately controlled in the range from about 0.1 at% to 10 at% in the above-described manner. Furthermore, since the carbon film depositing apparatus according to the present invention is capable of reducing the supply of the source gas for forming the amorphous $SiO_2$, it becomes possible to control the content of $SiO_2$ within the carbon film in the range from about 0.01 at% to 10 at%.

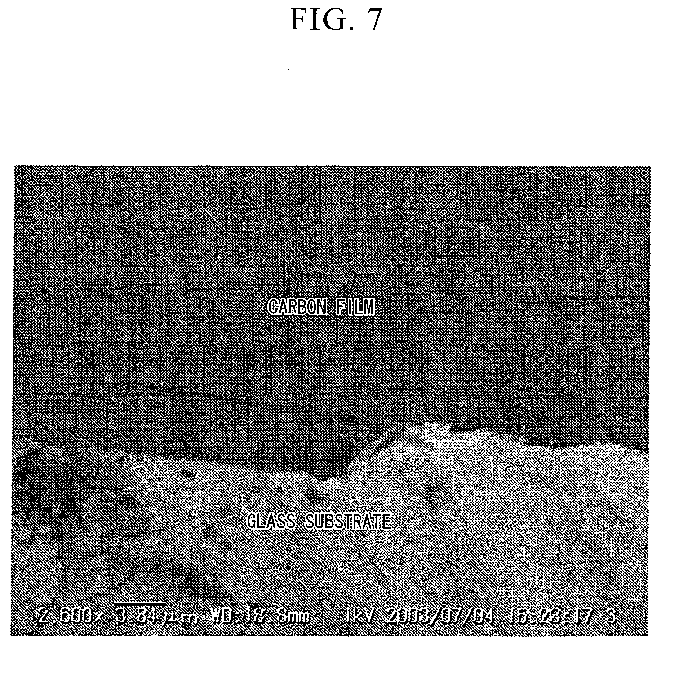

The carbon film was observed with a scanning electron microscope (SEM). Specifically, a carbon film having a thickness of about 500 nm was formed on a borosilicate glass substrate having a diameter of 10 cm and a thickness of 1 mm. Then, the substrate was broken and inclined to observe the cross-sectional surface thereof. For preventing charge-up caused by the fact that the glass substrate and the diamond film are insulators, a relatively low acceleration voltage of 1 kV was used to observe the cross-sectional surface thereof at a relatively low magnification factor of about 7000 times. The results of the observation are shown in FIG. 7. As shown in FIG. 7, the film was considerably planar and no distinct unevenness was observed at this magnification factor.

The surface of the carbon film was observed by an atomic force microscope (AFM) to evaluate the surface roughness. In this case, for suppressing the effect of the surface roughness of the substrate on the surface roughness of the film as much as possible, the film was formed on a mirror-polished quartz disk (10 mm diameter × 3 mm thickness) with a small surface roughness (arithmetic mean height Ra = 0.9 to 1.2 nm) and used as a sample to be measured. The AFM apparatus used was a nanoscope scanning probe microscope manufactured by Digital Instruments Corporation, and a canti-lever mono-crystal silicon production rotation probe Tap300 for use in a scanning probe microscope manufactured by Digital Instruments Corporation was used as the canti-lever. A tapping mode was used for the measurement, and observation was carried out at a scanning size of 1 $\mu$m and at a scanning rate of 1.0 Hz.

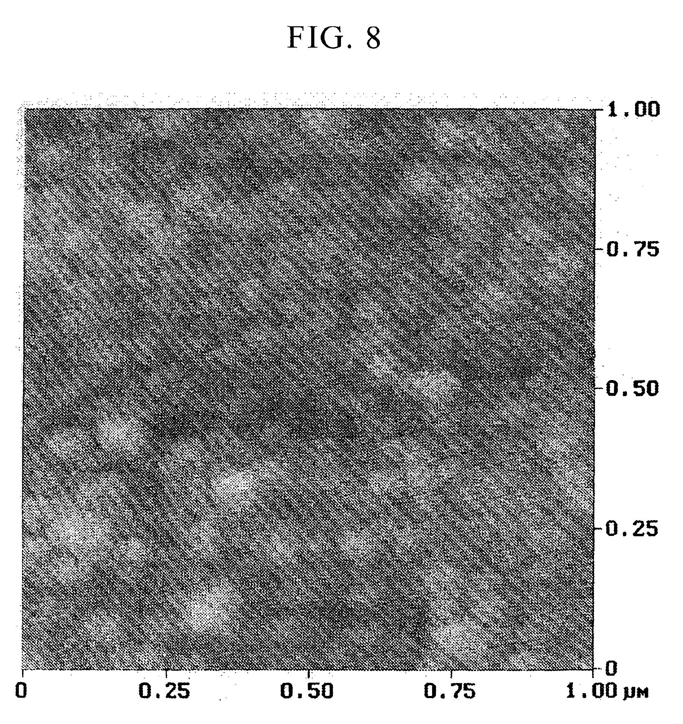

The results of observation of the film surface by an atomic force microscope (AFM) are shown in FIG. 8. For the image processing of the observation result and the evaluation of the surface roughness, a standard apparatus measurement and analysis computer software Nanoscope IIIa ver. 4.43r8 for the AFM apparatus was used. By the analysis for the observation results, the surface roughness Ra of the film was found to be 3.1 nm. Evaluation was also carried out for many other samples, and it was confirmed that, although the surface roughness differed depending on the deposition condition of the film, the surface roughness was in the range from 2.6 nm to 15 nm in terms of Ra. The surface roughness of the quartz disk substrate prior to deposition of the film was also measured in the same manner, and was found to be in the range from 0.9 nm to 1.2 nm in terms of Ra.

The arithmetic average height Ra is described in detail in, for example, "JIS B 0601-2001" or "ISO 4287-1997".

Transmittance of the carbon film to visible light was measured. As a sample, a carbon film of the present invention formed on a borosilicate glass wafer substrate having a diameter of 10 cm and a thickness of 1 mm was used. As a transmittance measuring apparatus, UV/Vis/NIR Spectrometer Lambda 900 manufactured by Perkin Elmer Inc. was used, and transmittance was measured in a wavelength region from 300 nm to 800 nm. In the measurement, light from a light source was divided into two optical paths, and one path was applied to the sample on which the film was formed and the other path was applied to a glass substrate on which the carbon film was not formed. In this manner, the transmittance spectrum of the sample and that of the glass substrate were simultaneously measured, and the transmittance spectrum of the carbon film itself was determined by subtracting the spectrum of the glass substrate from the spectrum of the sample. For carrying out measurement and analysis, a computer software for measurement and analysis for the apparatus, UV-Winlab ver. X1.7A manufactured by Perkin Elmer Inc., was used.

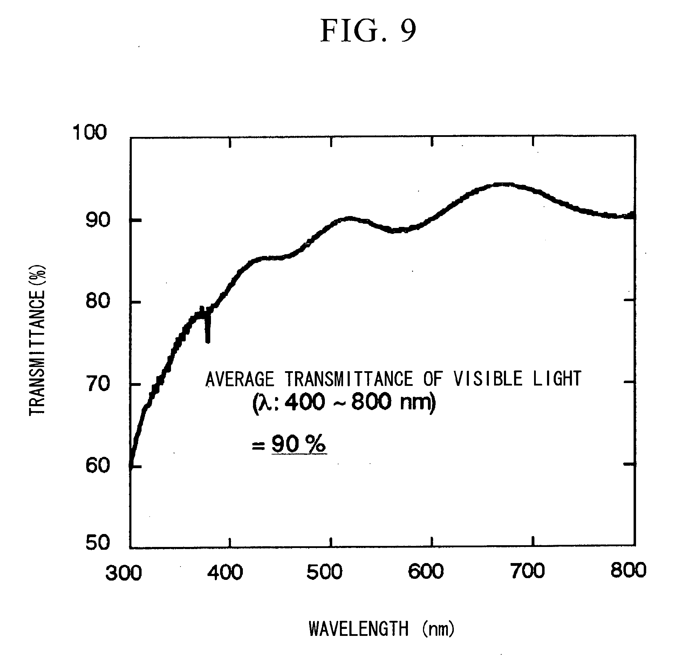

An example of the measured transmission spectrum of the film is shown in FIG 9. The thickness of the film was about 500 nm. The average transmittance at a wavelength in the visible light range from 400 nm to 800 nm was determined from the spectrum, and was found to be about 90%. As a result, it was found that the transparency was extremely high as an unpolished carbon film. Especially, it was found that the film had an extremely high transmittance, even when compared with a typical unpolished thin diamond film.

The refractive index of the carbon film was measured by phase difference measurement. A sample prepared by forming a carbon film of the present invention on a borosilicate glass wafer substrate having a diameter of 10 cm and a thickness of 1 mm and cutting the substrate into about 20 mm square was used. A phase difference measuring apparatus NPDM-1000 manufactured by Nikon Corporation was used as a measuring apparatus, and M-70 was used as a spectrophotometer. A xenon lamp was used as a light source, and Si-Ge was used as a detector. Further, Gramthomson was used as a polarizer and an analyzer, and the number of revolutions of the polarizer was set at 1. Measurement was carried out at an incident angle of 65° and 60°, a measuring wavelength in the range from 350 nm to 750 nm, and a pitch of 5 nm. The spectrum of the measured phase difference $\Delta$ and the amplitude reflectivity $\psi$ was compared with calculation models and fitted, so as to approach the measured values ($\Delta$, $\psi$). The refractive index, the extinction coefficient and the film thickness were determined based on the results of the best fitting between the measured values and the theoretical values. The calculation was carried out on the assumption that each layer of the sample was an isotropic medium.

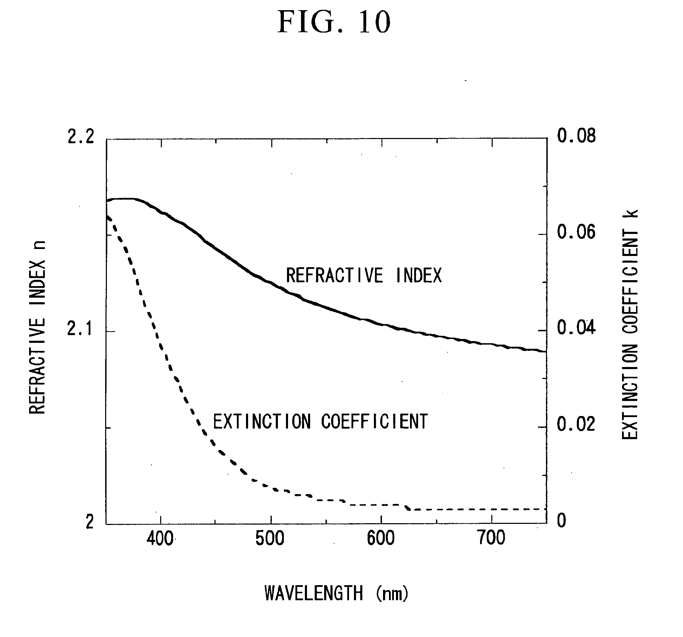

FIG 10 shows the wavelength dependence of the refractive index and the extinction coefficient in the measurement of the phase difference. From FIG 10, the evaluation result of the film thickness was about 440 nm. It was found that the film had a high refractive index of 2.1 or more in the entire wavelength region of the measurement. Further, the refractive index at the wavelength of 589 nm (Sodium D ray) was about 2.105.

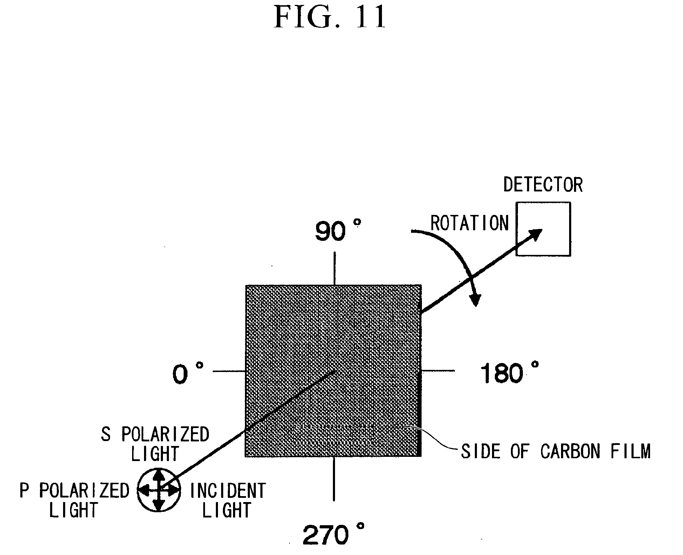

The birefringence of the carbon film was measured. A sample prepared by forming the carbon film of the present invention on a borosilicate glass wafer substrate having a diameter of 10 cm and a thickness of 1 mm and cutting the substrate into about 20 mm square was used. Measurement was carried out by a phase difference measuring method, and a phase difference measuring apparatus NPDM-1000 manufactured by Nikon Corporation was used as a measuring apparatus, M-70 was used as the spectrophotometer, and a halogen lamp was used as a light source. Si-Ge was used as the detector and Gramthomson was used as a polarizer and an analyzer. The number of revolutions of the polarizer was set at 1, and the measurement was carried out at the at an incident angle of 0°, a wavelength region of 400 nm to 800 nm and a pitch of 5 nm. Further, the dependence on the rotation angle was measured at a wavelength of 590 nm. Measurement was carried out in the arrangement shown in FIG. 11. In FIG. 11, during rotation of a sample, a phase difference $\Delta = \Delta S - \Delta P$ (phase difference between S polarized light and p polarized light) at the rotation angle was monitored, and wavelength dispersion measurement was carried out by setting an angle exhibiting the maximum phase difference as the direction of the maximum phase difference. The measurement light was incident from a diamond film. The measurement wavelength for the measurement of dependence of rotation angle was set at 590 nm.
Measurement was also carried out in the same manner with respect to the borosilicate glass used as the substrate, and was compared with the glass substrate having the carbon film formed thereon, so as to evaluate the birefringence of the carbon film.

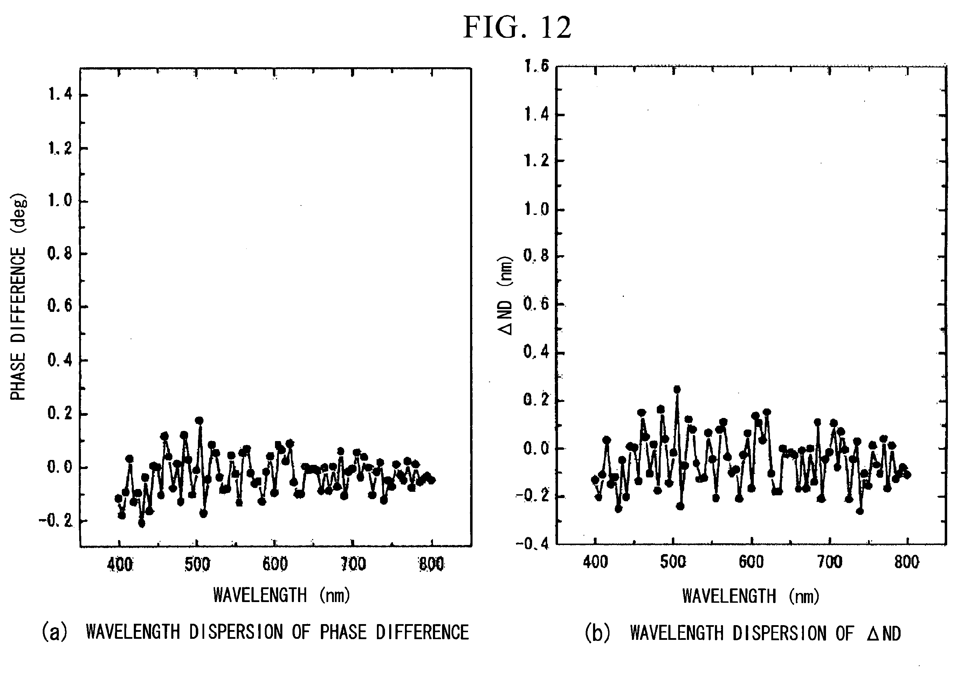

A typical example of the measurement results are shown in FIG. 12. In this example, the thickness of the carbon film was about 200 nm. First, as a result of measuring the dependence of the phase difference on the rotation angle, it was shown that the dependence was the same as that of the borosilicate glass used as the substrate. The direction of the maximum phase difference was determined on the basis of the measurement, and the sample was rotated in this direction to measure the phase difference and the wavelength dispersion of $\Delta$nd. FIG. 12 shows the results of the measurements. The drawing in FIG. 12(a) shows the wavelength dispersion of the phase difference and the drawing in FIG. 12(b) shows a calculated value for $\Delta$nd (nm) = wavelength (nm) $\times$ phase difference/360. Both the drawings in FIGS. 12(a) and 12(b) show a difference spectrum obtained by subtracting the measured value or the calculated value of the glass substrate only. From the drawings, it can be seen that the phase difference and $\Delta$nd are substantially 0, and hence, the film hardly shows birefringence.

An experiment on the adhesion of the carbon film to the glass substrate was carried out. Samples prepared by forming carbon films having thickness of about 280 nm, 600nm, and 2.2 $\mu$m, respectively, on a borosilicate glass wafer substrate having a diameter of 10 cm and a thickness of 1 mm and cutting respective substrates each into about 20 mm square were used.

With respect to the three samples, a flatwise experiment was carried out to evaluate the adhesion strength. A universal material experiment apparatus, Model 5565 manufactured by Instron Corporation, was used as a measuring apparatus and a crosshead displacement rate method was used as a measurement method. A jig was bonded with an adhesive to each of the sample diamond film and the glass substrate, and an adhesion strength test (flatwise test) was carried out by a crosshead displacement rate method at a measuring temperature of room temperature (23°C) to obtain a load-displacement diagram. The load upon initial fracture was read from the obtained diagram, and the adhesion strength was evaluated based on a value obtained by dividing the load upon initial fracture by the adhesion area. The experiment was carried out at a speed of 0.5 mm/min. The data processing system "Merlin" manufactured by Instron Corporation was used for the data processing.

As a result of the measurement, it was found that delamination did not occur at the interface between the glass and the carbon film, and delamination occurred at the interface between the adhesive and the jig in all of the samples. Therefore, the adhesion strength between the glass and the film could not be evaluated. However, it was found that the adhesion strength was at least 0.30 MPa or more.

Thus adhesion of the film to the glass substrate was evaluated by a scratch method using a Nano Indenter-scratch option. In the scratch method, the surface of the sample was scratched while applying a load on a diamond tip (in other words, the sample was scratched while indenting the diamond tip therein), and the adhesion was evaluated by the vertical load when the film was delaminated (critical delamination load).

As a measuring apparatus, Nano Indenter XP manufactured by MTS System Corporation was used, and Test Works 4 manufactured by MTS System Corporation, which is a standard computer software for measurement and analysis for the apparatus, was used. XP (diamond Cube corner type) was used as the indenter (tip). Measurement was carried out under conditions of a maximum indentation load in the range from 20 mN to 250 mN, a profile load of 20 $\mu$N, a scratch distance of 500 $\mu$m, the number of measuring points of 10, a measuring point interval of 50 $\mu$m, and a measuring ambient temperature of 23°C (room temperature).

The maximum indentation load was determined by carrying out an indentation experiment before the scratch experiment, and estimating the load to reach the substrate based on a load-displacement (indentation depth) curve.

The profile load is a load applied to an indenter upon scanning the sample surface with a minute load (profile step) before the scratch experiment in order to detect the shape of the sample surface.

A sample for the measurement prepared by forming the diamond film according to the present invention on a borosilicate glass wafer substrate having a diameter of 10 cm and a thickness of 1 mm and cutting the substrate into about 10 mm square was used. The sample was adhered to a sample support by using a crystal bond (hot melting adhesive) to carry out the measurement.

The scratch experiment was carried out by the following three steps.

First step: surface profile with a minute load

In this step, the surface shape was detected.

Second step: pre-profile → scratch → post profile

In this step, the scratch experiment was carried out while actually applying a load.

Third step: surface re-profile

In this step, the surface property of scratch flaws could be recognized.

The steps were carried out on every measuring point, and the adhesion strength was evaluated as scratch hardness on every measuring point.

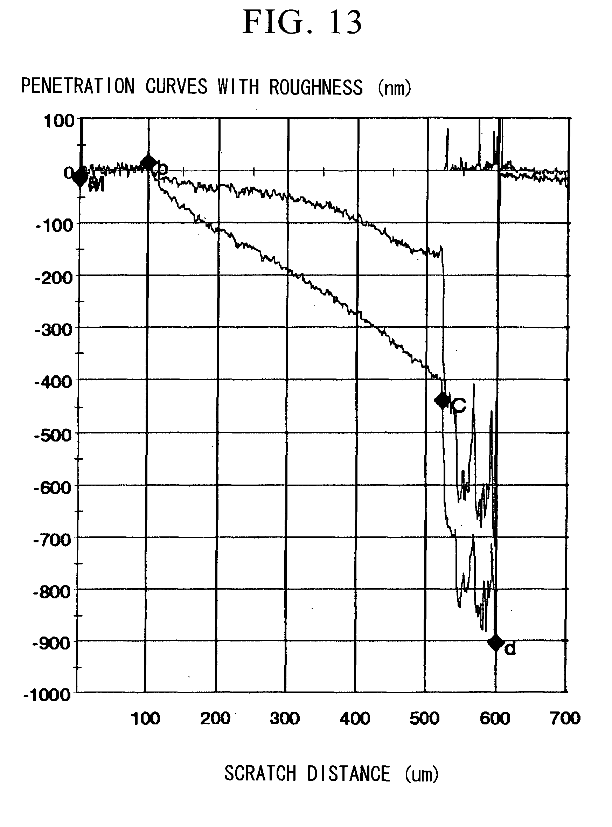

FIG. 13 shows an example of the result of the scratch test at a certain 1 measuring point of a carbon film having a thickness of 600 nm. In FIG. 13, the abscissa represents the scratch resistance and the ordinate represents the indentation depth. The maximum indentation load in this example was 20 mN. The drawing shows the three steps in the measurement. In the drawing, the indentation depth increases abruptly between the scratch distance of 500 nm and the final point, and this is a typical example of the delamination phenomenon. The scratch hardness H of the sample is determined from the delamination starting point as follows:

$$H = P/A,$$

wherein P denotes the vertical load at the delamination position and A denotes the contact area at the delamination starting point. A was estimated as follows:

$$A = 2.5981 \times ht^2/3 \text{ (ht: indentation depth at the delamination starting point).}$$

In this manner, the scratch experiment was carried out on 10 measuring points of each sample, and an average of significant measuring results was taken, which was defined as the scratch hardness of the sample. With respect to the sample shown in FIG 13, it was found that the scratch hardness reached 110 GPa, and hence, the adhesion was extremely high. Further, the standard deviation of the scratch hardness was about 6.2, and hence, the deviation depending on the measuring points was small.

In other samples (film thickness: about 280 nm), the carbon film did not delaminate even when the indenter reached the substrate. Thus, these samples exhibited high adhesion such that it could not to be evaluated by this method.

For evaluating the electric characteristic of the carbon film according to the invention, electric resistance measurement and Hall effect measurement were carried out. The measurements will be described below. The electric resistance measuring apparatus and Hall effect measuring apparatus used was Resi Test Model 8310S equipment manufactured by Toyo Corporation. The sample holder used was model VHT manufactured by Toyo Corporation. The measured sample was a carbon film having a thickness of 500 nm formed on a Pyrex (registered trademark) glass substrate having a thickness of 1 mm by the above-described method. Specifically, the measurement was performed with respect to a carbon film cut together with the glass substrate into a size of 4 mm square. As electrodes, Ti was deposited with a thickness of 50 nm in the shape of a circle having a diameter of 0.3 mm by vacuum vapor deposition on four corners of the sample. Further, Pt with a thickness of 50 nm and Au with a thickness of 100 nm were deposited on the Ti electrodes to prevent oxidation of the Ti electrodes. The electrodes were heat-treated in an argon atmosphere at 400°C for stabilization. The resultant was attached to a sample support made of high resistance alumina, and wiring of a gold wire having a φ of 250 μm was performed by supersonic bonding to the electrode.

Measurement of the electric resistance was carried out in an atmosphere of helium at 1 mbar. Measurement was carried out by raising the temperature by 25°C from room temperature up to 400°C.

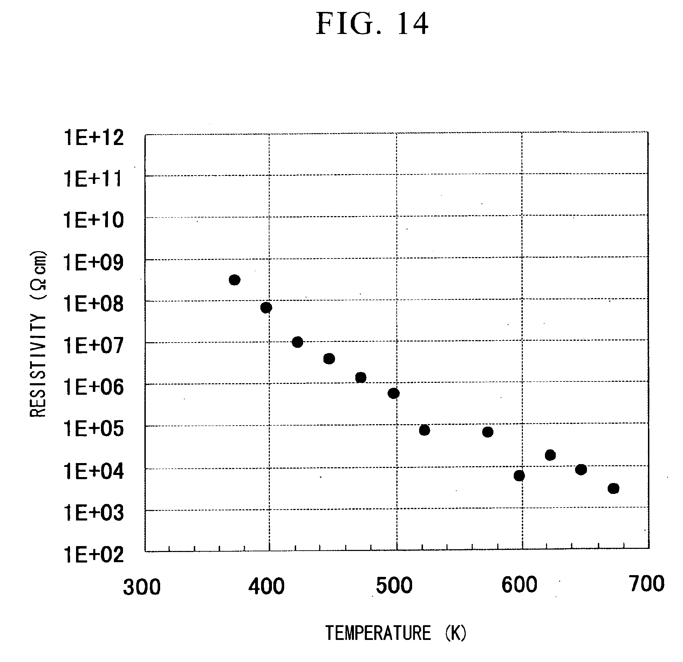

FIG 14 shows the temperature dependence of the electric resistivity of the sample. At 100°C or lower, the sample exhibited an extremely high resistance exceeding $1 \times 10^9$ Ωcm which is the upper limit of the measurable range of the measuring equipment, and hence, accurate measurement could not be performed. By extrapolation of measuring data at 100°C or higher, it was presumed that the electric resistivity at room temperature was $1 \times 10^{10}$ Ωcm or more. Further, at 400°C, it also exhibited a resistance value as high as $1 \times 10^3$ Ωcm or more.

Although determination of the electro-conductivity type by the Hall effect measurement was tried, it could not be determined whether it was p-type or n-type due to the high resistance.

The above-described electrical properties show that the carbon film according to the present invention functions as an excellent electric insulating film.

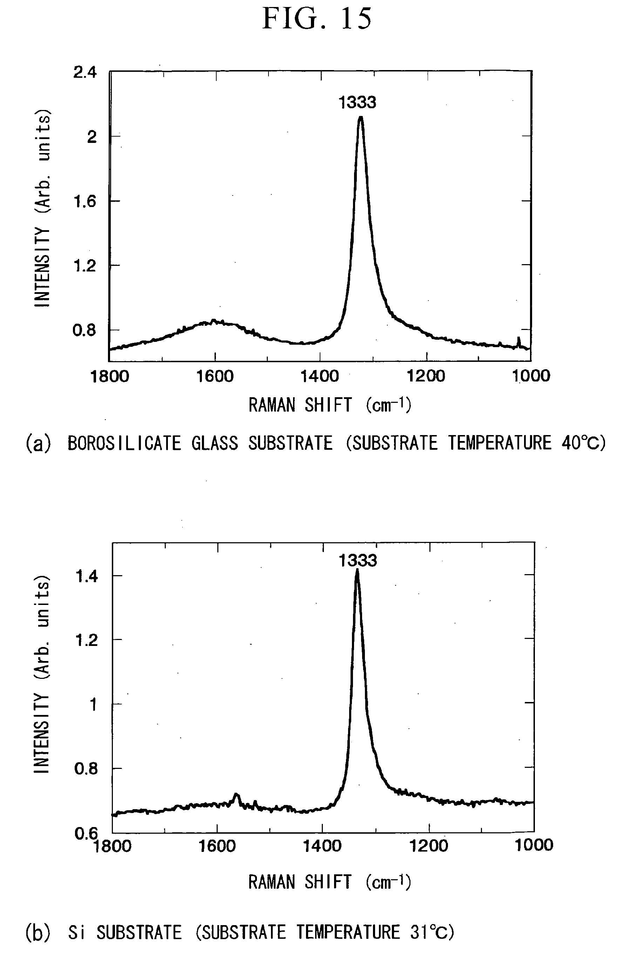

Formation of the carbon film was tried at a CVD treatment temperature of about room temperature by the technique according to the present invention. FIG. 15(a) shows a Raman scattering spectrum of a carbon film formed at a substrate temperature of 41°C on the borosilicate glass substrate (which had a diameter of 10 cm and a thickness of 1 mm). (The substrate temperature was measured by contacting a thermocouple with the substrate.) A peak showing the formation of the carbon film according to the present invention was clearly confirmed at Raman Shift of 1333 cm$^{-1}$. The full width at half maximum of the peak was 35 cm$^{-1}$. Thus, it was found that a carbon film could be formed on a glass substrate at a treatment temperature of about room temperature by the technique according to the present invention. On the other hand, FIG. 15(b) shows a Raman scattering spectrum of a carbon film formed at a substrate temperature of 31 °C on a Si substrate (which had a diameter of 5 cm and a thickness of 0.28 mm). (The substrate temperature was measured by contacting a thermocouple with the substrate.) A peak showing the formation of a carbon film according to the present invention was clearly confirmed at Raman Shift of 1333 cm$^{-1}$. The full width at half maximum of the peak was 20 cm$^{-1}$. Thus, it was found that a carbon film could be formed on a Si substrate at a treatment temperature of about room temperature by the technique according to the present invention.

Carbon films were formed on glass substrates other than the borosilicate glass and substrates other than glass such as metal and plastic. Specifically, the following substrates were used.

Glass

- soda lime glass: 150 × 150 × t5 mm and 300 × 300 × t3 mm
- quartz: φ10 × t2 mm and 50 × 26 × t0.1 mm.

Metal

- copper: 20 × 20 × t3 mm, 150 mm × 150 mm × t2 mm, and 300 × 300 × t3 mm
- iron: 20 × 20 × t3 mm and 150 mm × 150 mm × t2 mm
- Stainless steel (SUS 430): 20 × 20 × t2 mm and 150 mm × 150 mm × t2 mm
- titanium: φ10 × t2 mm
- molybdenum: φ30 × t5 mm
- aluminum: 20 × 20 × t2 mm and 150 mm × 150 mm × t2 mm
- cemented carbide: φ30 × t5 mm

Plastic

- polyether sulfon (PES): 20 × 20 × t1 mm

Other

- silicon (single crystal (001) face): φ100 × t5 mm

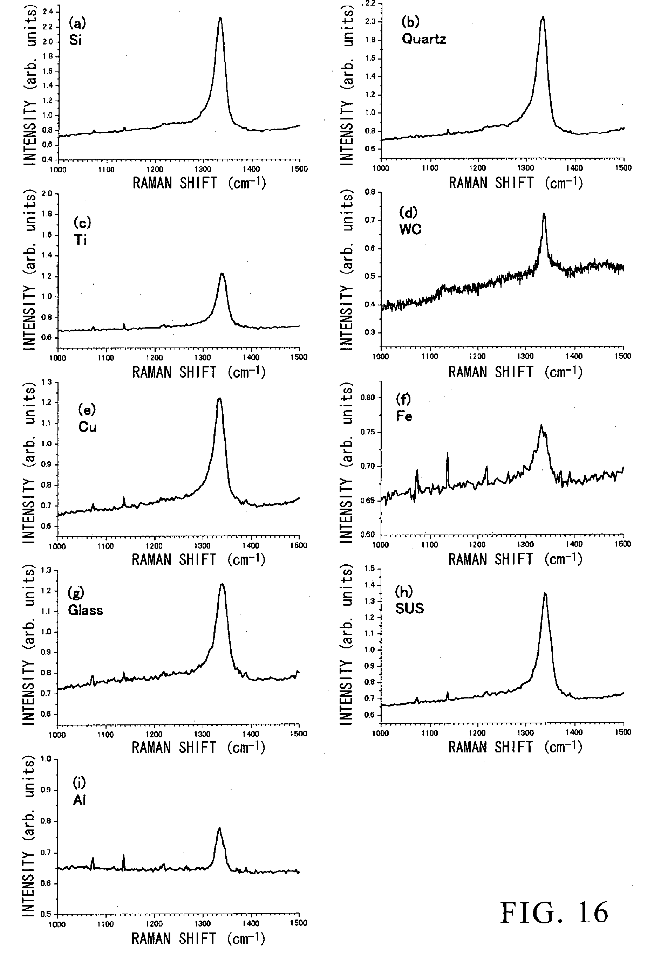

Following the surface wave plasma CVD treatment, the carbon film according to the present invention was formed on each of the substrates. The Raman scattering spectra of the films formed on the substrates are shown in FIG. 16. The Raman scattering spectroscopy was performed by the above-described method. In each of the spectra, a peak was observed near the Raman shift at 1333 cm$^{-1}$, which is the characteristic peak of the carbon film according to the present invention.

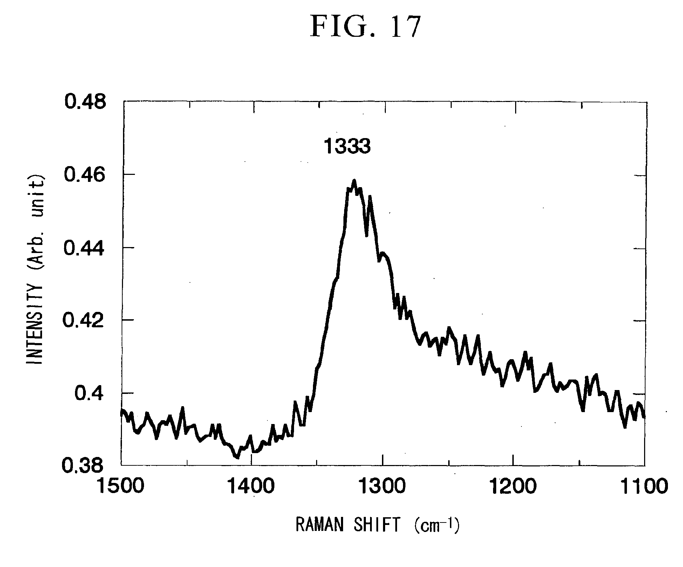

A carbon film was formed on a PPS (polyphenylene sulfide) resin substrate by the method of the present invention. A PPS substrate with a size of $50 \times 50 \times t2$ mm was used. The substrate temperature during the surface wave plasma treatment was 28°C. Following the surface wave plasma CVD treatment, a carbon film was formed on the substrate. The Raman scattering spectrum of the film is shown in Fig. 17. The Raman scattering spectroscopy was performed by the above-described method. In the obtained spectrum, a peak was observed near the Raman shift at 1333 cm$^{-1}$. Thus, it was confirmed that a carbon film according to the present invention was formed.

With respect to diamond films formed on the copper substrate and the stainless steel substrate, the adhesion strength was evaluated by a scratch test. Measurement was performed in the same manner as in the evaluation for the scratch hardness by the scratch method using the Nano Indenter scratch option described above. The sample used for the evaluation was a copper substrate having a size of $20 \times 20 \times t3$ mm and a stainless steel (SUS 430) substrate having a size of $20 \times 20 \times t2$ mm each having a diamond film formed thereon. The thickness of the diamond film formed on each of the substrates was about 600 nm. The maximum indentation load in this example was 1 mN for the film on the copper substrate and 10 mN for the film on the stainless steel substrate. Other measuring conditions were the same as those for the method described above.

As a result of the scratch experiment, it was found out that delamination of the film did not occur even when the indenter was indented by 1 $\mu$m which was larger than the film thickness, and hence, the evaluation of the adhesion strength was difficult. Nevertheless, since delamination did not occur even at the indentation depth larger than the film thickness, it can be considered that the adhesion was excellent.

A discontinuous carbon film composed of aggregates of carbon grains according to the present invention was formed on a substrate by the method of the present invention. Upon depositing nano diamond grains, cluster diamond grains, graphite cluster diamond grains, adamantane, derivative thereof, or multimeric compounds thereof on a substrate before carrying out the surface wave plasma CVD treatment according to the method of the invention, the deposition density of them to the substrate can be reduced by considerably lowering the concentration thereof to a dispersion medium or a solvent for dispersing or dissolving them. In this manner, the surface density of the nucleus formation generation of diamond upon CVD treatment can be lowered, and formation of a discontinuous film (not a continuous film) on the substrate becomes possible. In this case, the grain size of the carbon grains constituting the discontinuous film can be controlled by the time for the surface wave plasma CVD treatment (wherein the size becomes smaller as the time is shortened, and the size becomes larger as the time is prolonged).

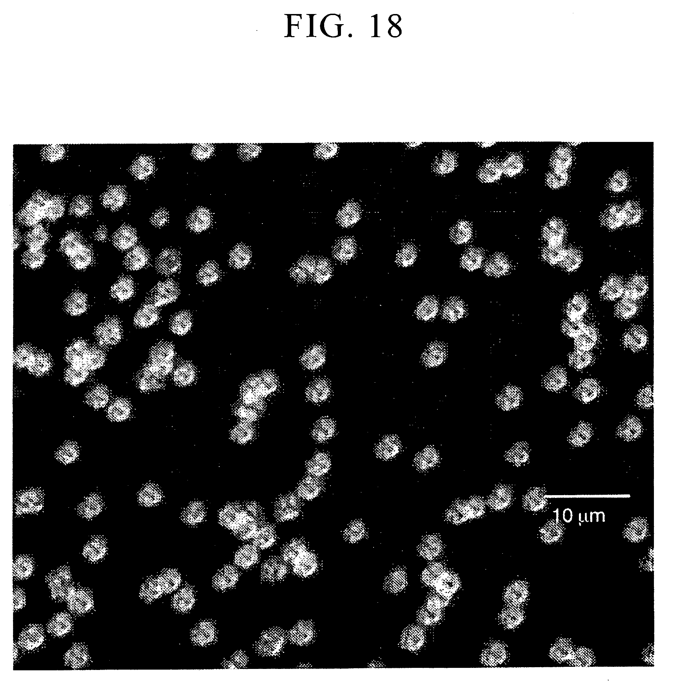

FIG. 18 shows an optical photomicrograph of the discontinuous carbon film formed in this manner on a borosilicate glass substrate. An optical microscope, LEITZ DMR manufactured by Leica Co. was used for the observation. For taking the photomicrograph, a standard digital camera for the microscope, DFC 280 manufactured by Leica Co., and IM50 ver. 4.0 Release 117 as the picturing and analyzing computer software were used. In this example, a borosilicate glass wafer substrate having a diameter of 10 cm and a thickness of 1 mm was immersed in a liquid dispersion in which graphite cluster diamond grains were dispersed considerably thinly in ethanol (concentration: about 0.01 wt%) before the film deposition treatment, and pre-treatment was carried out by a supersonic treatment. Subsequently, a surface plasma CVD treatment was carried out for about 7 hours. The average grain size of the diamond grains shown in FIG. 18 was about 3 $\mu$m. In this example, it is considered that a single grain is an aggregate of 200 carbon grains (crystallites) in average. The surface density of the grains in this example was about $5 \times 10^6$ cm$^{-2}$, which was considered to be substantially equal to the deposition density of the graphite cluster diamond grains deposited on a substrate by the pre-treatment.

The discontinuous film composed of the carbon grain aggregates shown in FIG. 18 contains a large number of isolated carbon grains on the glass substrate. From such a discontinuous carbon film, a carbon grain powder can be obtained by removing the substrate by hydrofluoric acid treatment or the like.

Thermal conductivity of the carbon film according to the present invention formed on the silicon substrate was measured. The thickness of the carbon film was 1 $\mu$m. An optical exchange method was used as a measuring method (with respect to the optical exchange method, see "Calorimetry and Thermal Analysis Handbook" (Japan Society of Calorimetry and Thermal Analysis, JSCTA) edition, Maruzen Co., Ltd.). As a result, a thermal diffusivity of $0.758 \times 10^{-4}$ m$^2$/S was obtained at 25°C. Simultaneously, the specific heat and density of the carbon film were measured. By multiplying them with the thermal diffusivity, the thermal conductivity of 137 W/mK of the carbon film according to the present invention was obtained.

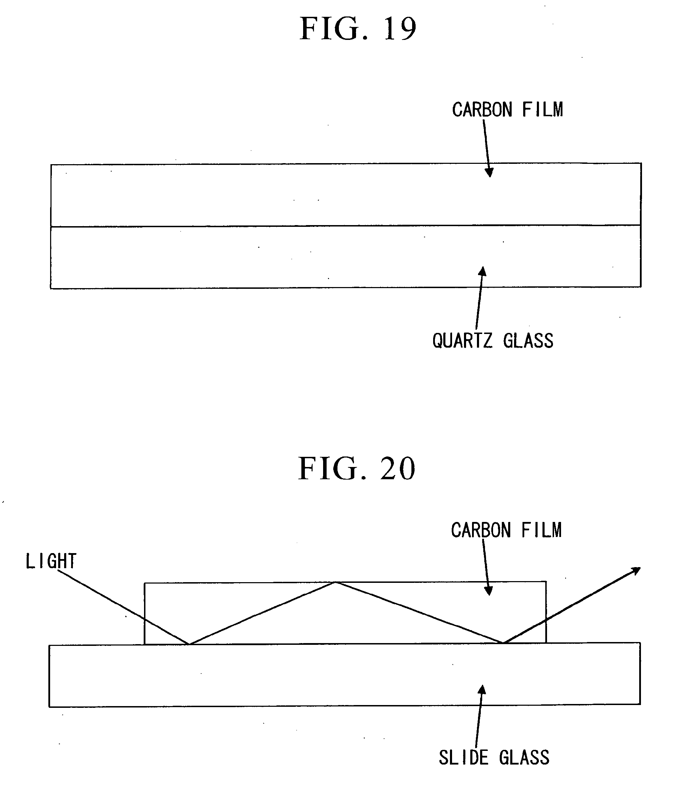

As shown in FIG. 19, the carbon film according to the present invention was laminated on a quartz glass plate, and the operation thereof as a grinding tool was confirmed. The experimented quartz glass had a size of $\phi$ 30 mm and 1 mm thickness, and a carbon film of the present invention was deposited with a thickness of 500 nm on the surface of the quartz glass to form a laminate. The surface of the quartz glass was polished before deposition of the carbon film, and it was confirmed by observation using an atomic force microscope (AFM) that it had a flatness of about 1 nm in terms of surface roughness Ra. The laminate was frictionally rubbed with a titanium plate for 100 cycles reciprocally and the change of Ra before and after the rubbing was measured by AFM. The Ra of the titanium plate before rubbing was 100 nm, whereas the Ra after rubbing was 20 nm, and hence, improvement of the flatness was confirmed. Thus, it was confirmed that the laminate using the carbon film according to the present invention functions as a grinding tool.

The carbon film according to the present invention was laminated on glass, and the optical confinement effect was demonstrated. The carbon film according to the present invention was deposited with a thickness of 200 nm on the surface of a typical slide glass (25 mm $\times$ 75 mm, about 1 mm thickness) to form a laminate. FIG 20 shows the structure of an optical device. When light was entered from a mercury lamp at an angle of about 45° from one end of the surface of the carbon film of the laminate, the light was emitted from the other end which was 40 mm away from the end where the light was entered. In this manner, it was confirmed that the light from the mercury lamp incident from one end of the carbon film repeats total reflection at the boundary surface between the carbon film and the slide glass and at the boundary surface between the carbon film and air, and is propagated while being confined as far as the other end. As described above, it was found that the carbon film according to the present invention can be utilized as an optical device such as an optical waveguide channel by utilizing the high refractive index thereof.

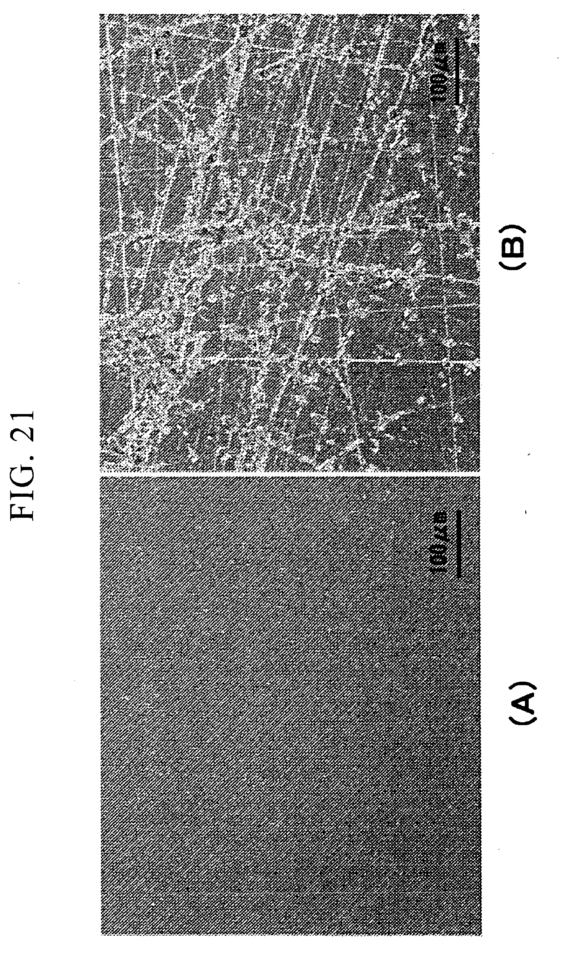

The carbon film according to the present invention was coated on glass to demonstrate the scratch flaw resistance effect. The carbon film according to the present invention was coated with a thickness of 300 nm on the surface of a borosilicate glass having a diameter of 10 cm and a thickness of 1 mm. Then, it was rubbed with No. 400 sand paper by 800 experimenters. The results are shown in FIG. 21(A). Further, FIG. 21 (B) is a diagram illustrating a photograph showing the results of carrying out the same experiment for borosilicate glass not coated with the carbon film according to the present invention. The glass coated with the carbon film according to the present invention had no scratch flaws. In contrast, glass not coated with the carbon film according to the present invention suffered scratch flaws. Thus, it was found that the carbon film according to the present invention exhibited high scratch flaw resistance effect for optical glass. Therefore, coating of the carbon film according to the present invention enables application use, for example, to optical glass, lenses, and spectacles with improved scratch flaw resistance.

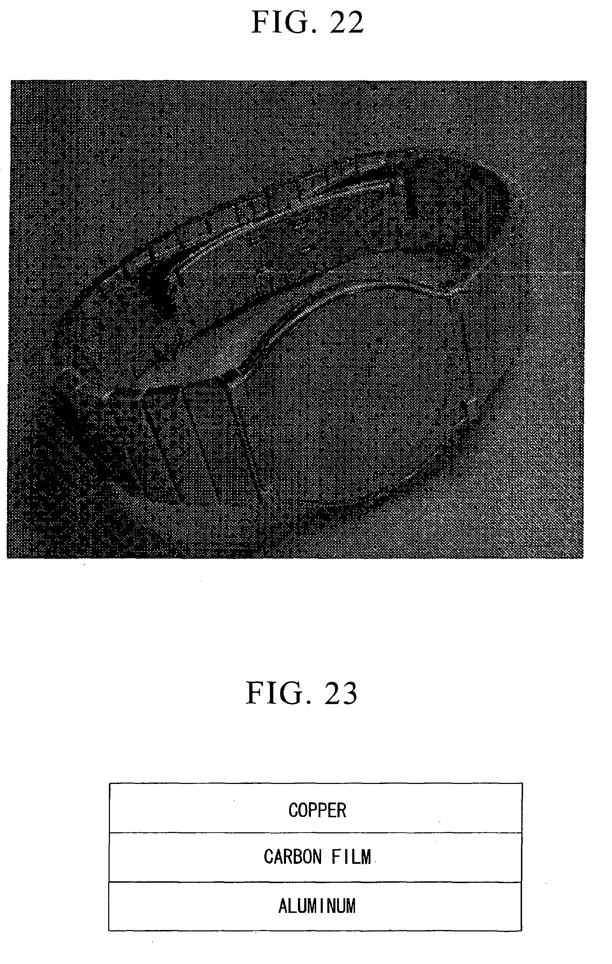

A carbon film according to the present invention was deposited with a thickness of 300 nm on quartz glass, and a wrist watch provided with the coated quartz glass as a wind proof was formed as shown in FIG. 22, to demonstrate the function of a wind proof. The surface of the wind proof member was rubbed with No. 1000 sand paper for 100 cycles reciprocally. However, the wind proof member did not suffer any scratch flaws. Thsu, it was confirmed that a wrist watch provided with a laminate of the carbon film of the present invention and the quartz glass as a wind proof has a characteristic that the wind proof surface is resistant to scratch flaws.

A carbon film according to the invention with a thickness of 500 nm was deposited on a thin aluminum plate having a thickness of 0.3 mm to form a laminate. Further, an electronic circuit pattern was formed with copper on the carbon film to form an electronic circuit substrate. FIG 23 is a schematic view illustrating the electronic circuit substrate. It was confirmed that the electric insulation property of copper and aluminum interposing the carbon film therebetween was excellent. The substrate may not only be made of aluminum, but may be made of other materials. It was confirmed that the laminate using the carbon film according to the present invention functions as an electronic circuit substrate.

The carbon film according to the present invention was coated on a glass plate, a silicon substrate, a stainless plate, a copper plate, an aluminum plate, an alumina plate each having a diameter of 10 cm and a thickness of 1 mm, and chemical resistance against various chemicals was investigated. The carbon film according to the present invention was coated with a thickness of 300 nm on each of the substrates. Fluorinated acid, nitric acid, hydrochloric acid, sulfuric acid, hydrogen peroxide solution, and aqueous solution of sodium hydroxide were applied onto the surface coated with the carbon film, and then allowed to stand for 1 hour. As a result, it was found that the carbon film was not eroded by any of the above-described chemicals, and all of the substrates were protected. Thus, it was found that the carbon film according to the present invention is effective as a protection film.

**Claims**

1.  A carbon film comprising: carbon grains having substantially the same grain size in the range of 1 nm to 1,000 nm, and preferably in the range of 2 nm to 200 nm, in the thickness-wise direction of said carbon film; and an amorphous substance for suppressing generation of impurities accompanied by formation of the carbon grains and/or for suppressing growth of the carbon grains, said amorphous substance existing at least on the surfaces of the carbon grains in a grain boundary between the carbon grains and/or gaps between the carbon grains.

2.  The carbon film according to Claim 1, wherein said carbon grains have an approximate spectrum curve obtained by superimposing a peak fitting curve B at a Bragg angle (28 $\pm$ 0.5°) of 41.7° and a baseline on a peak fitting curve A at a Bragg angle ($2\theta \pm 0.5°$) of 43.9° in an X-ray diffraction spectrum by a CuK$\alpha_1$ ray, and wherein the peak fitting curve A, the peak fitting curve B, and the baseline are represented by a Pearson VII function, an asymmetric normal distribution function, and a linear function, respectively.

3.  The carbon film according to Claim 2, wherein the intensity ratio of the peak fitting curve B to the peak fitting curve A is at at a minimum 5% and at a maximum 90%.

4.  The carbon film according to any one of Claims 1 to 3, wherein the impurities accompanied by formation of said carbon grains is amorphous carbon or graphite.

5.  The carbon film according to any one of Claims 1 to 4, wherein said amorphous substance is at least one member selected from the group consisting of Si, $SiO_2$, Ti, $TiO_2$, $HfO_2$, and ZnO.

6.  The carbon film according to Claim 5, wherein said amorphous substance exists within said carbon film in the range from 0.01 to 10 at%, and preferably in the range from 0.1 to 10 at%.

7.  The carbon film according to any one of Claims 1 to 6, wherein said amorphous substance is formed at a furnace temperature in the range from room temperature to 600°C.

8.  The carbon film according to any one of Claims 1 to 7, which exhibits an average transmittance of 60% or more in the wavelength region of 400 to 800 nm, an electrical resistivity of $1 \times 10^7$ Ωcm or more at 100°C, a refractive index of 1.7 or more at a wavelength of 589 nm, a thermal conductivity of 20 W/mK or more at 25°C, and surface flatness with a surface roughness (Ra) of 20 nm or less.

9.  A carbon film laminate comprising the carbon film of any one of Claims 1 to 8 deposited on a substrate.

10. The carbon film laminate according to Claim 9, which further comprises an adhesion-reinforcing layer provided between said substrate and said carbon film for improving adhesion between both.

11. The carbon film laminate according to Claim 9 or 10, wherein said substrate is at least one member selected from the group consisting of insulating materials including glass, quartz, and diamond; semiconductors including silicon; conductive materials including iron, stainless steel, molybdenum, aluminum, copper, and titanium; ceramic materials including tungsten carbide, alumina, and boron nitride; and plastic materials including PES, PET, PPS, and polyimide.

12. The carbon film laminate according to Claim 10, wherein the adhesion-reinforcing layer comprises amorphous Si and/or $SiO_2$.

13. A method of forming a carbon film comprising continuously or discontinuously supplying into a chamber of a plasma generation furnace a carbon-containing gas, a hydrogen gas, and a gas which forms an amorphous substance for suppressing generation of an impurity accompanied by formation of carbon grains and/or for suppressing growth of the carbon grains, in a plasma state toward a substrate in a downflow manner, the substrate temperature being in the range of room temperature to 600°C.

14. The method according to Claim 13, wherein said amorphous substance is at least one member selected from the group consisting of Si, $SiO_2$, Ti, $TiO_2$, $HfO_2$, and ZnO.

15. The method according to Claim 13, wherein said gas for forming said amorphous substance is a silicon-containing gas.

16. The method according to Claim 15, wherein said silicon-containing gas is generated by exposing plasma to bulk-like silicon or $SiO_2$.

17. The method according to Claim 15 or 16, wherein the concentration of said silicon-containing gas is 10 mol% or less.

18. The method according to Claim 13, which further comprises adding carbon dioxide.

19. The method according to Claim 13, which further comprises performing a heat treatment after depositing said carbon film.

20. A method of forming a carbon film laminate, comprising:

    providing a substrate;
    forming an adhesion-reinforcing layer on said substrate at a furnace temperature within the range of room temperature to 600°C by a plasma CVD using a surface wave; and
forming a carbon film on said adhesion-reinforcing layer by the method of Claim 13.

21. A carbon film deposition apparatus comprising:

a plasma-generating unit;
a supply unit for generating a silicon-containing gas by exposing plasma to bulk-like silicon or $SiO_2$, and supplying the silicon-containing gas together with source gases including carbon-containing gas and hydrogen in a plasma state toward a substrate in a downflow manner; and
a cooling unit for cooling the substrate temperature to a temperature within the range of room temperature to 600°C.

22. An optical device provided with the carbon film of Claim 1 or the carbon film laminate of Claim 9.

23. An optical glass provided with the carbon film of Claim 1 or the carbon film laminate of Claim 9.

24. A wrist watch provided with the carbon film of Claim 1 or the carbon film laminate of Claim 9.

25. An electronic circuit substrate provided with the carbon film of Claim 1 or the carbon film laminate of Claim 9.

26. A grinding tool provided with the carbon film of Claim 1 or the carbon film laminate of Claim 9.

27. A protection film provided with the carbon film of Claim 1 or the carbon film laminate of Claim 9.

# FIG. 1

# FIG. 2

FITTING CURVE

BASELINE

INTENSITY (COUNTS)

2θ (DEGREE)

EP 1 911 859 A1

# FIG. 3

(A)

(B)

EP 1 911 859 A1

FIG. 4

## FIG. 5

EP 1 911 859 A1

# FIG. 6

(a) INTERFACE

(b) OUTERMOST SURFACE

(c) DIFFRACTION IMAGE

(d) EELS SPECTRUM

# FIG. 7

FIG. 8

# FIG. 9

AVERAGE TRANSMITTANCE OF VISIBLE LIGHT
(λ: 400 ~ 800 nm)

= 90 %

# FIG. 10

# FIG. 11

DETECTOR

ROTATION

90°

0°

180°

S POLARIZED
LIGHT

P POLARIZED          INCIDENT
LIGHT                LIGHT

SIDE OF CARBON FILM

270°

# FIG. 12

(a) WAVELENGTH DISPERSION OF PHASE DIFFERENCE

(b) WAVELENGTH DISPERSION OF △ND

EP 1 911 859 A1

# FIG. 13

PENETRATION CURVES WITH ROUGHNESS (nm)

SCRATCH DISTANCE (um)

# FIG. 14

# FIG. 15

(a) BOROSILICATE GLASS SUBSTRATE (SUBSTRATE TEMPERATURE 40°C)

(b) Si SUBSTRATE (SUBSTRATE TEMPERATURE 31°C)

FIG. 16

# FIG. 17

# FIG. 18

10 μm

# FIG. 19

CARBON FILM

QUARTZ GLASS

# FIG. 20

LIGHT

CARBON FILM

SLIDE GLASS

FIG. 21

(A)

(B)

# FIG. 22

# FIG. 23

| COPPER |
|---|
| CARBON FILM |
| ALUMINUM |

# FIG. 24

MEASUREMENT POINT 2
(SURFACE OF CARBON GRAIN)

MEASUREMENT POINT 3
(GRAIN BOUNDARY OR GAP)

MEASUREMENT POINT 1
(INSIDE OF CARBON GRAIN)

CARBON GRAIN

AMORPHOUS SiO₂ LAYER

SUBSTRATE

MEASUREMENT POINT 4
(AMORPHOUS LAYER)

MEASUREMENT POINT 6
(AMORPHOUS LAYER)

5nm

MEASUREMENT POINT 5
(INSIDE OF CARBON GRAIN
DIRECTLY ABOVE AMORPHOUS LAYER)

# FIG. 25

SUBSTANCE SUPPRESSING GENERATION OF
IMPURITY AND/OR GROWTH OF CARBON GRAINS

CARBON GRAIN

CARBON GRAIN

ADHESION-REINFORCING
LAYER

SUBSTRATE

EP 1 911 859 A1

FIG. 26

(A)

(B)

EP 1 911 859 A1

## INTERNATIONAL SEARCH REPORT

| | International application No. |
|---|---|
| | PCT/JP2006/313315 |

A. CLASSIFICATION OF SUBJECT MATTER
*C23C16/26*(2006.01)i, *C01B31/02*(2006.01)i, *C03C17/22*(2006.01)i

According to International Patent Classification (IPC) or to both national classification and IPC

B. FIELDS SEARCHED

Minimum documentation searched (classification system followed by classification symbols)
C23C16/26, C01B31/02, C03C17/22

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | Kazuo TSUGAWA et al., "Glass Kibanjo eno Nanocrystal Diamond no Daimenseki Seimaku", NEW DIAMOND, 25 April, 2004 (25.04.04), Vol.20, No.2, pages 16 to 17 | 1-23,25-27<br>24 |
| Y<br>A | JP 63-195266 A (Semiconductor Energy Laboratory Co., Ltd.), 12 August, 1988 (12.08.88), Claims & US 5013579 A | 24<br>1-23,25-27 |
| A | JP 2004-176132 A (Toppan Printing Co., Ltd.), 24 June, 2004 (24.06.04), Full text (Family: none) | 1-27 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>04 September, 2006 (04.09.06) | Date of mailing of the international search report<br>19 September, 2006 (19.09.06) |
|---|---|
| Name and mailing address of the ISA/<br>Japanese Patent Office | Authorized officer |
| Facsimile No. | Telephone No. |

Form PCT/ISA/210 (second sheet) (April 2005)

50

**INTERNATIONAL SEARCH REPORT**

International application No.

PCT/JP2006/313315

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 9-025110 A (The Ishizuka Research Institute, Ltd.), 28 January, 1997 (28.01.97), Example 1 & EP 0753481 A1 & US 6337060 B1 | 1-27 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP HEI1095694 A

### Non-patent literature cited in the description

- *Diamond and Related Materials,* 1998, vol. 7, 1639-1646
- *Thin Solid Films,* 1995, vol. 270, 154-159
- **HIROSHI MAKITA.** *New Diamond,* 1996, vol. 12 (3), 8-13
- **HIDEO SUGAI.** Plasma Electronics. Ohmusha, Ltd, 2000, 124, 125
- **HIDEO SUGAI.** Plasma Electronics. Ohmusha, Ltd, 2000, 58
- Kagaku Daijiten (Chemical Encyclopedia. Tokyo Kagaku Dojin
- Hakumaku (Thin Film) Handbook. Ohmusha Ltd, 1983, 375
- Introduction Practice of Powder X-ray Analysis-Introduction to Rietveld Method. Asakura Publishing Ltd